# EUROPEAN PATENT APPLICATION

(11) **EP 4 528 118 A1**
(43) Date of publication of application: **26.03.2025**
(21) Application number: 24795620.4
(22) Date of filing: 07.03.2024
(51) Int. Cl.: F16C 11/04, H04M 1/02

(54) **ROTATING SHAFT MECHANISM AND ELECTRONIC DEVICE**

(30) Priority: 27.04.2023 CN 202310481738
(71) Applicant: Huawei Technologies Co., Ltd., Shenzhen, Guangdong 518129 (CN)
(72) Inventor: SHI, Tuo, Shenzhen, Guangdong 518129 (CN); SHEN, Hewen, Shenzhen, Guangdong 518129 (CN); ZHONG, Ding, Shenzhen, Guangdong 518129 (CN); ZHAN, Qiang, Shenzhen, Guangdong 518129 (CN)
(74) Representative: Huawei European IPR
(86) International application number: PCT/CN2024/080604
(87) International publication number: WO 2024/222233

(57) **Abstract**

This application provides a hinge mechanism and an electronic device. The hinge mechanism includes a main shaft, a synchronization assembly, a first housing mounting bracket, and a second housing mounting bracket. The first housing mounting bracket and the second housing mounting bracket are located on two opposite sides of the main shaft, and the synchronization assembly is located between the first housing mounting bracket and the second housing mounting bracket. The synchronization assembly includes a first connecting rod, a second connecting rod, and a third connecting rod. The first connecting rod and the third connecting rod are rotatably connected via the second connecting rod, the first connecting rod is rotatably connected to the main shaft, and axes along which all the parts are rotatably connected are parallel to each other and do not coincide with each other. The third connecting rod is slidably connected to the second housing mounting bracket. The first housing mounting bracket is provided with a first track slot, and the first connecting rod slides along the first track slot, so that the first housing mounting bracket and the second housing mounting bracket synchronously rotate toward each other or away from each other relative to the main shaft. In a folding process of the electronic device in which the hinge mechanism is used, stress on a flexible display is relatively uniform, to help improve structural reliability of the flexible display.

## Description

### CROSS-REFERENCE TO RELATED APPLICATIONS

This application claims priority to Chinese Patent Application No. 202310481738.3, field with the China National Intellectual Property Administration on April 27, 2023 and entitled "HINGE MECHANISM AND ELECTRONIC DEVICE", which is incorporated herein by reference in its entirety.

### TECHNICAL FIELD

This application relates to the field of electronic device technologies, and in particular, to a hinge mechanism and an electronic device.

### BACKGROUND

Gradual maturity of flexible display technologies brings great changes to display of an electronic device. Foldable mobile phones, tablet computers, or wearable electronic devices with flexible displays, are an important trend of evolutions for intelligent electronic devices in the future.

A key component of a foldable electronic device is a flexible display featured by continuousness and foldability. A hinge mechanism, as an important component for folding the foldable electronic device, can drive the flexible display to be flattened or bent in unfolding and folding processes of the foldable electronic device. Currently, with the improvement of economy, users impose higher requirements for the foldable electronic device, and structural reliability of the flexible display is a key factor that affects user experience. Therefore, how to improve the structural reliability of the flexible display has become a topic widely studied by a person skilled in the art currently.

### SUMMARY

This application provides a hinge mechanism and an electronic device, to improve structural reliability of a flexible display of the electronic device, thereby improving structural reliability of the electronic device.

According to a first aspect, this application provides a hinge mechanism. The hinge mechanism may be used in a foldable electronic device, the hinge mechanism is disposed corresponding to a bendable part of a flexible display of the electronic device, and the electronic device is unfolded or folded via the hinge mechanism. During specific disposing, the hinge mechanism may include a main shaft, a synchronization assembly, a first housing mounting bracket, and a second housing mounting bracket, the first housing mounting bracket and the second housing mounting bracket are respectively disposed on two opposite sides of the main shaft, and the synchronization assembly is located between the first housing mounting bracket and the second housing mounting bracket. The synchronization assembly includes a first connecting rod, a second connecting rod, and a third connecting rod, the second connecting rod is located between the first connecting rod and the third connecting rod, the second connecting rod is rotatably connected to the first connecting rod, the second connecting rod is rotatably connected to the third connecting rod, and an axis along which the second connecting rod is rotatably connected to the first connecting rod is parallel to and does not coincide with an axis along which the second connecting rod is rotatably connected to the third connecting rod. In addition, the first connecting rod is rotatably connected to the main shaft, and an axis along which the first connecting rod rotates around the main shaft is parallel to and does not coincide with the axis along which the second connecting rod is rotatably connected to the first connecting rod. The third connecting rod is rotatably connected to the main shaft, and the third connecting rod is slidably connected to the second housing mounting bracket. The first housing mounting bracket is provided with a first track slot, and the first connecting rod is capable of sliding along the first track slot. In this application, a form of the first track slot may be obtained through fitting based on processes in which the first housing mounting bracket and the second housing mounting bracket synchronously move toward each other and away from each other relative to the main shaft, so that the first connecting rod is capable of sliding along the first track slot. In this way, the first housing mounting bracket and the second housing mounting bracket synchronously rotate toward each other or away from each other relative to the main shaft.

According to the hinge mechanism provided in this application, in a folding process in which the electronic device changes from an unfolded state to a folded state, the first housing mounting bracket rotates clockwise relative to the main shaft, so that the first connecting rod slides along the first track slot to an end that is of the first track slot and that is away from the main shaft, and the first connecting rod rotates around the main shaft. The rotation of the first connecting rod may drive the second connecting rod to rotate relative to the first connecting rod, so that the second connecting rod drives the third connecting rod to rotate counter-clockwise relative to the main shaft. In addition, because the third connecting rod is slidably connected to the second housing mounting bracket, the third connecting rod may drive the second housing mounting bracket to rotate counter-clockwise, so that the first housing mounting bracket and the second housing mounting bracket synchronously rotate toward each other. In addition, in a process in which the electronic device changes from the folded state to the unfolded state, a movement direction of each structure is opposite to a movement direction of each structure in the process in which the electronic device changes from the unfolded state to the folded state. Details are not described herein. In this case, the first housing mounting bracket and the second housing mounting bracket synchronously move away from each other.

In the hinge mechanism provided in embodiments of this application, the first connecting rod is rotatably connected to the main shaft and the second connecting rod, the second connecting rod is rotatably connected to the third connecting rod, and axes of rotating shafts are parallel to each other and do not coincide with each other, so that the first connecting rod, the main shaft, the second connecting rod, and the third connecting rod can be connected to form a four-link mechanism. A structure of the four-link mechanism is relatively simple, so that the synchronization assembly occupies small space in the hinge mechanism while the first housing mounting bracket and the second housing mounting bracket can synchronously rotate toward each other or away from each other, to help implement a compact design for the hinge mechanism.

In a possible implementation of this application, the main shaft includes a base, the base is provided with a first arc-shaped slot, the third connecting rod includes a first arc-shaped rotating block, the first arc-shaped rotating block is accommodated in the first arc-shaped slot, and the first arc-shaped rotating block is capable of sliding along a slot surface of the first arc-shaped slot. Therefore, the third connecting rod is rotatably connected to the main shaft via a virtual shaft. This can help reduce space occupied by the third connecting rod on the main shaft, to help implement a compact design for the hinge mechanism.

In this application, when the second connecting rod is specifically rotatably connected to the third connecting rod, the second connecting rod may be rotatably connected to the first arc-shaped rotating block. This can help reduce a size of the synchronization assembly, to implement a compact design for the hinge mechanism.

In a possible implementation of this application, the hinge mechanism further includes a rotating module, the rotating module includes a first rotating assembly and a second rotating assembly, the first rotating assembly is located between the first housing mounting bracket and the second housing mounting bracket, and the second rotating assembly is located between the first housing mounting bracket and the second housing mounting bracket. The first rotating assembly includes a first swing arm, a first support arm, and a first connector, the first swing arm is rotatably connected to the main shaft, the first swing arm is slidably connected to the first housing mounting bracket, the first support arm is rotatably connected to the second housing mounting bracket, the first connector is located between the first swing arm and the first support arm, the first connector is rotatably connected to the first swing arm, and the first connector is rotatably connected to the first support arm. In addition, the main shaft is provided with a second track slot, and the first connector is capable of moving along the second track slot, for limitation on a movement track of the first connector. The second rotating assembly includes a second swing arm, a second support arm, and a second connector, the second swing arm is rotatably connected to the main shaft, the second swing arm is slidably connected to the second housing mounting bracket, the second support arm is rotatably connected to the first housing mounting bracket, the second connector is located between the second swing arm and the second support arm, the second connector is rotatably connected to the second swing arm, and the second connector is rotatably connected to the second support arm. In addition, the main shaft is provided with a third track slot, and the second connector is capable of moving along the third track slot, for limitation on a movement track of the second connector.

Based on the foregoing hinge mechanism in this application, in the process in which the electronic device changes from the unfolded state to the folded state, the first housing mounting bracket and the second housing mounting bracket move toward each other. When the first housing mounting bracket drives the first swing arm to rotate around the main shaft clockwise, the first swing arm may drive the first connector to move toward the first swing arm in the first track slot of the main shaft, to drive the first support arm to rotate around the main shaft counter-clockwise. When the second housing mounting bracket drives the second swing arm to rotate around the main shaft counter-clockwise, the second swing arm may drive the second connector to move toward the second swing arm in the second track slot of the main shaft, to drive the second support arm to rotate around the main shaft clockwise. In the process in which the electronic device changes from the folded state to the unfolded state, the first housing mounting bracket and the second housing mounting bracket move away from each other. When the first housing mounting bracket drives the first swing arm to rotate around the main shaft counter-clockwise, the first swing arm may drive the first connector to move toward the first support arm in the first track slot of the main shaft, to drive the first support arm to rotate around the main shaft clockwise. When the second housing mounting bracket drives the second swing arm to rotate around the main shaft clockwise, the second swing arm may drive the second connector to move toward the second support arm in the second track slot of the main shaft, to drive the second support arm to rotate around the main shaft counter-clockwise. In this way, folding and unfolding functions of the hinge mechanism may be implemented.

Some existing hinge mechanisms need to thicken a rotating assembly connected to a main shaft to ensure stability of the mechanisms. In this way, both the main shaft and the hinge mechanism are very heavy. If the main shaft and the hinge mechanism are forcibly thinned, strength of the rotating assembly is easily weakened, thereby greatly affecting reliability of the hinge mechanisms and shortening a life of the electronic device. The foregoing hinge mechanism in this application has a simplified structure. According to the foregoing structural relationship, the first connector and the second connector slide in the main shaft to link the first swing arm, the second swing arm, the first support arm, and the second support arm on the left and right sides. Therefore, the first connector and the second connector do not need to be manufactured with very thick thickness sections to travel back and forth in the first track slot and the second track slot of the main shaft. In addition, because the first connector and the second connector are respectively connected to the first swing arm (the second swing arm) and the first support arm (the second support arm), the first connector (the second connector) has a sufficient length extension along a vertical axial direction to have sufficient strength. This can ensure reliability of the hinge mechanism. In this way, the thickness of the main shaft and the thickness of the entire electronic device can be reduced, and reliability of the hinge mechanism can be maintained, so that the entire hinge mechanism is light, thin, and reliable.

In addition, because the first connector is capable of moving in the first track slot according to a specified track, and the second connector is capable of moving in the second track slot according to a specified track, uncontrolled movement of the first connector and the second connector in an entire folding and unfolding process can be avoided, and random movement of the first housing mounting bracket and the second housing mounting bracket can further be avoided, to ensure structural stability and movement stability of the entire hinge mechanism. In some cases, the first track slot and the second track slot are appropriately designed, so that an outer tangent line of the hinge mechanism can keep a constant length in the entire folding and unfolding process, and a flexible display covering the surface of the hinge mechanism can also basically keep a length unchanged. In this way, squeezing or pulling on the flexible display can be effectively avoided, to improve structural reliability of the flexible display and further improve structural reliability of the electronic device.

In a possible implementation of this application, the main shaft includes a base and a cover, the cover covers the base, the base is provided with a second arc-shaped slot, the cover includes a first protrusion disposed toward the second arc-shaped slot, and a gap between a surface of the first protrusion and a slot surface of the second arc-shaped slot may be used as the second track slot. In addition, the first connector may include a first arc-shaped surface and a second arc-shaped surface, and when the electronic device is in the unfolded state and the folded state, the first arc-shaped surface abuts against the surface of the first protrusion, and the second arc-shaped surface abuts against the slot surface of the second arc-shaped slot. In this way, the surface of the first protrusion and the slot surface of the second arc-shaped slot limit the first connector to the second track slot, so that when the hinge mechanism is in the unfolded state and the folded state, the first connector is relatively stable without any gap-caused shake, and reliability of the hinge mechanism is improved in the foregoing two states.

In addition, the base may further be provided with a fourth arc-shaped slot, and the cover further includes a third protrusion disposed toward the fourth arc-shaped slot. A gap between a surface of the third protrusion and a slot surface of the fourth arc-shaped slot is used as the third track slot, the second connector includes a third arc-shaped surface and a fourth arc-shaped surface, and when the electronic device is in the unfolded state and the folded state, the third arc-shaped surface abuts against the surface of the third protrusion, and the fourth arc-shaped surface abuts against the slot surface of the fourth arc-shaped slot. In this way, the surface of the third protrusion and the slot surface of the fourth arc-shaped slot limit the second connector to the third track slot, so that when the hinge mechanism is in the unfolded state and the folded state, the second connector is relatively stable without any gap-caused shake, and reliability of the hinge mechanism is improved in the foregoing two states.

In a possible implementation of this application, in the process in which the electronic device changes from the unfolded state to the folded state, the first arc-shaped surface abuts against the surface of the first protrusion, and a gap exists between the second arc-shaped surface and the slot surface of the second arc-shaped slot. However, in the process in which the electronic device changes from the folded state to the unfolded state, the second arc-shaped surface abuts against the slot surface of the second arc-shaped slot, and a gap exists between the first arc-shaped surface and the surface of the first protrusion. Therefore, a movement track of the first connector in the second track slot in the process in which the electronic device changes from the unfolded state to the folded state is different from a movement track of the first connector in the second track slot in the process in which the electronic device changes from the folded state to the unfolded state. This helps improve design flexibility of the hinge mechanism.

In addition, in the process in which the electronic device changes from the unfolded state to the folded state, the third arc-shaped surface abuts against the surface of the third protrusion, and a gap exists between the fourth arc-shaped surface and the slot surface of the fourth arc-shaped slot. In the process in which the electronic device changes from the folded state to the unfolded state, the fourth arc-shaped surface abuts against the slot surface of the fourth arc-shaped slot, and a gap exists between the third arc-shaped surface and the surface of the third protrusion. Therefore, a movement track of the second connector in the third track slot in the process in which the electronic device changes from the unfolded state to the folded state is different from a movement track of the second connector in the third track slot in the process in which the electronic device changes from the folded state to the unfolded state. This helps improve design flexibility of the hinge mechanism.

In this application, the movement track of the first connector in the second track slot in the process in which the electronic device changes from the unfolded state to the folded state may be further enabled to be the same as the movement track of the first connector in the second track slot in the process in which the electronic device changes from the folded state to the unfolded state. Specifically, the surface of the first protrusion may be equidistant from the slot surface of the second arc-shaped slot, and in this case, the second track slot is an equal-width slot. In the processes in which the electronic device changes from the unfolded state to the folded state and from the folded state to the unfolded state, the first arc-shaped surface abuts against the surface of the first protrusion, and the second arc-shaped surface abuts against the slot surface of the second arc-shaped slot. This can help improve movement stability of the first connector in the second track slot. Similarly, the surface of the third protrusion may also be equidistant from the slot surface of the fourth arc-shaped slot, and in this case, the third track slot is an equal-width slot. In addition, in the processes in which the electronic device changes from the unfolded state to the folded state and from the folded state to the unfolded state, the third arc-shaped surface abuts against the surface of the third protrusion, and the fourth arc-shaped surface abuts against the slot surface of the fourth arc-shaped slot. In this way, the movement track of the second connector in the third track slot in the process in which the electronic device changes from the unfolded state to the folded state is the same as the movement track of the second connector in the third track slot in the process in which the electronic device changes from the folded state to the unfolded state, to improve movement stability of the second connector in the third track slot.

In a possible implementation of this application, the first arc-shaped surface of the first connector may be a circular arc surface, and the second arc-shaped surface may also be a circular arc surface. In this case, a sum of a radius of the first arc-shaped surface and a radius of the second arc-shaped surface may be equal to a spacing between the surface of the first protrusion and the slot surface of the second arc-shaped slot, to improve smoothness of movement of the first connector in the second track slot.

Similarly, the third arc-shaped surface of the second connector may be a circular arc surface, and the fourth arc-shaped surface may also be a circular arc surface. In this case, a sum of a radius of the third arc-shaped surface and a radius of the fourth arc-shaped surface may be equal to a spacing between the surface of the third protrusion and the slot surface of the fourth arc-shaped slot, to improve smoothness of movement of the second connector in the third track slot.

In this application, the first swing arm is rotatably connected to the main shaft. The base is provided with a third arc-shaped slot, the first swing arm includes a second arc-shaped rotating block, the second arc-shaped rotating block is accommodated in the third arc-shaped slot, and the second arc-shaped rotating block is capable of sliding along a slot surface of the third arc-shaped slot, for rotatable connection between the first swing arm and the main shaft. Therefore, the first swing arm is rotatably connected to the main shaft in a virtual shaft manner. This helps reduce space occupied by the first swing arm on the main shaft, to help implement a compact design for the hinge mechanism.

In addition, the second swing arm is also rotatably connected to the main shaft. The base is further provided with a fifth arc-shaped slot, the second swing arm includes a third arc-shaped rotating block, the third arc-shaped rotating block is accommodated in the fifth arc-shaped slot, and the third arc-shaped rotating block is capable of sliding along a slot surface of the fifth arc-shaped slot, for rotatable connection between the second swing arm and the main shaft. Therefore, the second swing arm is rotatably connected to the main shaft in a virtual shaft manner. This helps reduce space occupied by the second swing arm on the main shaft, to help implement a compact design for the hinge mechanism.

It may be understood that, for an outward folding electronic device, the first swing arm is rotatably connected to the main shaft via a virtual shaft or a solid shaft, and an axis center at which the first swing arm rotates around the main shaft is located on one side that is of the main shaft and that is away from the flexible display. In addition, the second swing arm is rotatably connected to the main shaft via a virtual shaft or a solid shaft, and an axis center at which the second swing arm rotates around the main shaft is located on the side that is of the main shaft and that is away from the flexible display.

To improve reliability of the connection between the first swing arm and the main shaft, in this application, the cover further includes a second protrusion disposed toward the third arc-shaped slot, and at least a part of the second arc-shaped rotating block is located between the second protrusion and the third arc-shaped slot, so that the first swing arm is limited to the main shaft via the second protrusion and the third arc-shaped slot, and the first swing arm may be prevented from falling off from the third arc-shaped slot.

In addition, the cover further includes a fourth protrusion disposed toward the fifth arc-shaped slot, and at least a part of the third arc-shaped rotating block is located between the fourth protrusion and the fifth arc-shaped slot, so that the second swing arm is limited to the main shaft via the fourth protrusion and the fifth arc-shaped slot, and the second swing arm may be prevented from falling off from the fourth arc-shaped slot.

In a possible implementation of this application, the first connector includes a first rotating shaft and a second rotating shaft, the first connector is rotatably connected to the first swing arm via the first rotating shaft, the first connector is rotatably connected to the first support arm via the second rotating shaft, and an axis of the first rotating shaft is parallel to and does not coincide with an axis of the second rotating shaft, so that the first swing arm and the first support arm can implement mutual pulling movement via the first connector.

The second connector includes a third rotating shaft and a fourth rotating shaft, the second connector is rotatably connected to the second swing arm via the third rotating shaft, the second connector is rotatably connected to the second support arm via the fourth rotating shaft, and an axis of the third rotating shaft is parallel to and does not coincide with an axis of the fourth rotating shaft, so that the second swing arm and the second support arm can implement mutual pulling movement via the second connector.

Specifically, when the first swing arm is rotatably connected to the first connector via the first rotating shaft, the second arc-shaped rotating block may be provided with a first mounting slot, and a slot opening of the first mounting slot is disposed toward the third arc-shaped slot. The first rotating shaft is mounted in the first mounting slot, a part of a surface of the first rotating shaft is in contact with a slot surface of the first mounting slot, and a part of the surface of the first rotating shaft is in contact with the slot surface of the third arc-shaped slot. The first rotating shaft is mounted in the opened first mounting slot of the second arc-shaped rotating block to be in contact with the slot surface of the third arc-shaped slot, so that a size of the second arc-shaped rotating block can be effectively reduced, and a thickness of the first mounting slot does not need to be increased due to a size of the first rotating shaft. This helps a compact design for the hinge mechanism.

In addition, the slot surface of the first mounting slot includes a first circular arc surface, the surface that is of the first rotating shaft and that is in contact with the slot surface of the first mounting slot is a second circular arc surface, and a center of the first circular arc surface coincides with a center of the second circular arc surface. In this way, the first rotating shaft rotates relative to the second arc-shaped rotating block in a process in which the second arc-shaped rotating block slides along the slot surface of the third arc-shaped slot, for rotatable connection between the first swing arm and the first rotating shaft.

The slot surface of the third arc-shaped slot is a third circular arc surface, the surface that is of the first rotating shaft and that is in contact with the slot surface of the third arc-shaped slot is a fourth circular arc surface, and a center of the third circular arc surface coincides with a center of the fourth circular arc surface. In this way, when the first rotating shaft slides along the slot surface of the third arc-shaped slot with the second arc-shaped rotating block, the first rotating shaft may further rotate relative to the second arc-shaped rotating block and the third arc-shaped slot, to help implement movement of the first connector relative to the main shaft.

Similarly, the third arc-shaped rotating block is provided with a second mounting slot, a slot opening of the second mounting slot is disposed toward the fifth arc-shaped slot, the third rotating shaft is mounted in the open second mounting slot to be in contact with the slot surface of the fifth arc-shaped slot, a part of a surface of the third rotating shaft is in contact with a slot surface of the second mounting slot, and a part of the surface of the third rotating shaft is in contact with the slot surface of the fifth arc-shaped slot. The second rotating shaft is mounted in the second mounting slot of the third arc-shaped rotating block, so that a size of the third arc-shaped rotating block can be effectively reduced, and a thickness of the second mounting slot does not need to be increased due to a size of the second rotating shaft. This helps a compact design for the hinge mechanism.

The second mounting slot may include a fifth circular arc surface, the surface that is of the third rotating shaft and that is in contact with the slot surface of the second mounting slot is a sixth circular arc surface, and a center of the fifth circular arc surface coincides with a center of the sixth circular arc surface. In addition, the slot surface of the fifth arc-shaped slot is a seventh circular arc surface, and the surface that is of the third rotating shaft and that is in contact with the slot surface of the fifth arc-shaped slot may be an eighth circular arc surface. In this case, a center of the seventh circular arc surface coincides with a center of the eighth circular arc surface. In this way, when the third rotating shaft slides along the slot surface of the fifth arc-shaped slot with the third arc-shaped rotating block, the third rotating shaft may further rotate relative to the third arc-shaped rotating block and the fifth arc-shaped slot, to help implement movement of the second connector relative to the main shaft.

In a possible implementation of this application, the first connector may include a plurality of first sub-connectors that are sequentially rotatably connected. In addition, the plurality of first sub-connectors may be located between the first swing arm and the first support arm, the first swing arm may be rotatably connected to a first sub-connector adjacent to the first swing arm, and the first support arm may be rotatably connected to a first sub-connector adjacent to the first support arm. The first swing arm and the first support arm are connected via the plurality of first sub-connectors. This can effectively improve speed uniformity in a process in which the first swing arm and the first support arm rotate around the main shaft, thereby improving smoothness of mutual pulling movement of the first swing arm and the first support arm.

In addition, the second connector may include a plurality of second sub-connectors that are sequentially rotatably connected. In addition, the plurality of second sub-connectors may be located between the second swing arm and the second support arm, the second swing arm may be rotatably connected to an adjacent second sub-connector, and the second support arm may be rotatably connected to an adjacent second sub-connector. The second swing arm and the second support arm are connected via the plurality of second sub-connectors. This can effectively improve speed uniformity in a process in which the second swing arm and the second support arm rotate around the main shaft, thereby improving smoothness of mutual pulling movement of the second swing arm and the second support arm.

According to a second aspect, this application further provides an electronic device. The electronic device includes a first housing, a second housing, a flexible display, and the hinge mechanism in the first aspect. The first housing and the second housing are respectively disposed on two opposite sides of the hinge mechanism, a first housing mounting bracket is fastened to the first housing, and a second housing mounting bracket is fastened to the second housing. The flexible display continuously covers the first housing, the second housing, and the hinge mechanism, and the flexible display is fastened to the first housing and the second housing. When the electronic device is in an unfolded state, the hinge mechanism, the first housing, and the second housing jointly flatly support the flexible display. This can ensure a complete form of the electronic device in the unfolded state. In a process in which the electronic device changes from the unfolded state to a folded state, the two housings synchronously rotate toward each other to drive the flexible display to rotate, and in a process in which the electronic device changes from the folded state to the unfolded state, the two housings synchronously rotate away from each other to drive the flexible display to rotate. This can effectively avoid deformation of the flexible display, and reduce a risk of damage to the flexible display.

### BRIEF DESCRIPTION OF DRAWINGS

FIG. 1 is a diagram of a structure of an electronic device in a folded state according to an embodiment of this application;
FIG. 2a is a diagram of a structure of an electronic device in an unfolded state according to an embodiment of this application;
FIG. 2b is a diagram of another structure of an electronic device in an unfolded state according to an embodiment of this application;
FIG. 3 is a diagram of a structure of a hinge mechanism according to an embodiment of this application;
FIG. 4 is an exploded view of the hinge mechanism shown in FIG. 3;
FIG. 5 is an enlarged view of a partial structure at an A position of the hinge mechanism shown in FIG. 3;
FIG. 6 is a B-B sectional view of the hinge mechanism shown in FIG. 5;
FIG. 7 is a diagram of a partial structure of a base according to an embodiment of this application;
FIG. 8 is a diagram of a structure of the hinge mechanism shown in FIG. 6 when an electronic device is in an intermediate state;
FIG. 9 is a diagram of a structure of the hinge mechanism shown in FIG. 8 when an electronic device is in a folded state;
FIG. 10 is a sectional view of a first connector of a hinge mechanism when an electronic device is in an unfolded state according to an embodiment of this application;
FIG. 11 is a diagram of a structure of a main shaft according to an embodiment of this application;
FIG. 12 is a diagram of a structure of a cover of the main shaft shown in FIG. 11;
FIG. 13 is a sectional view of a first connector of a hinge mechanism when an electronic device is in a folded state according to an embodiment of this application;
FIG. 14 is a diagram of a structure of a first connector according to an embodiment of this application;
FIG. 15 is a diagram of an assembly structure of a first connector and a main shaft according to an embodiment of this application;
FIG. 16 is a C-C sectional view of the hinge mechanism shown in FIG. 3;
FIG. 17 is a sectional view of a first swing arm of a hinge mechanism when an electronic device is in a folded state according to an embodiment of this application;
FIG. 18 is a diagram of a structure of a first rotating assembly according to an embodiment of this application;
FIG. 19 is a diagram of a structure of a first swing arm according to an embodiment of this application;
FIG. 20 is a diagram of a principle of a movement mechanism of a hinge mechanism according to an embodiment of this application;
FIG. 21 is a diagram of a partial structure of a hinge mechanism according to an embodiment of this application; and
FIG. 22 is a diagram of a structure of an inward folding electronic device in a folded state according to an embodiment of this application.

### Reference numerals:

1: hinge mechanism; 1a: bearing surface; 1b: third appearance surface;
101: main shaft; 1011: base; 10111: first arc-shaped slot; 101111: slot surface of the first arc-shaped slot;
10112: second arc-shaped slot; 101121: slot surface of the second arc-shaped slot; 10113: third arc-shaped slot; 101131: third circular arc surface;
10114: fourth arc-shaped slot; 101141: seventh circular arc surface; 10115: fifth arc-shaped slot; 101151: slot surface of the fifth arc-shaped slot;
1012: cover; 10121: first protrusion; 101211: surface of the first protrusion; 10122: second protrusion;
101221: surface of the second protrusion; 10123: first insertion part; 10124: third protrusion; 101241: surface of the third protrusion;
10125: fourth protrusion; 101251: surface of the fourth protrusion; 1013: second track slot; 1014: third track slot;
102: synchronization assembly; 1021: first connecting rod; 10211: guide structure; 1022: second connecting rod; 1023: third connecting rod;
10231: first arc-shaped rotating block; 1024: first shaft; 1025: second shaft; 1026: third shaft;
103: first housing mounting bracket; 1031: guide part; 10311: first track slot; 1032: first mounting part;
1033: second sliding groove;
104: second housing mounting bracket; 1041: first sliding groove; 1042: second mounting part; 1043: third sliding groove;
105: rotating module; 1051: first rotating assembly; 10511: first swing arm; 105111: second arc-shaped rotating block;
1051111: first recess; 1051112: first mounting slot; 10511121: first circular arc surface; 10512: first support arm;
10513: first connector; 105131: first rotating shaft; 1051311: second circular arc surface; 1051312: fourth circular arc surface;
105132: second rotating shaft; 105133: first arc-shaped surface; 105134: second arc-shaped surface;
1052: second rotating assembly; 10521: second swing arm; 105211: third arc-shaped rotating block; 1052111: second recess;
1052112: second mounting slot; 10521121: fifth circular arc surface; 10522: second support arm; 10523: second connector;
105231: third rotating shaft; 1052311: sixth circular arc surface; 1052312: eighth circular arc surface; 105232: fourth rotating shaft;
105233: third arc-shaped surface; 105234: fourth arc-shaped surface;
2: first housing; 2a: first support surface; 2b: first appearance surface; and
3: second housing; 3a: second support surface; 3b: second appearance surface; 4: flexible display; 5: display accommodation space.

### DESCRIPTION OF EMBODIMENTS

To make the objectives, technical solutions, and advantages of this application clearer, the following further describes this application in detail with reference to the accompanying drawings. Terms used in the following embodiments of this application are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

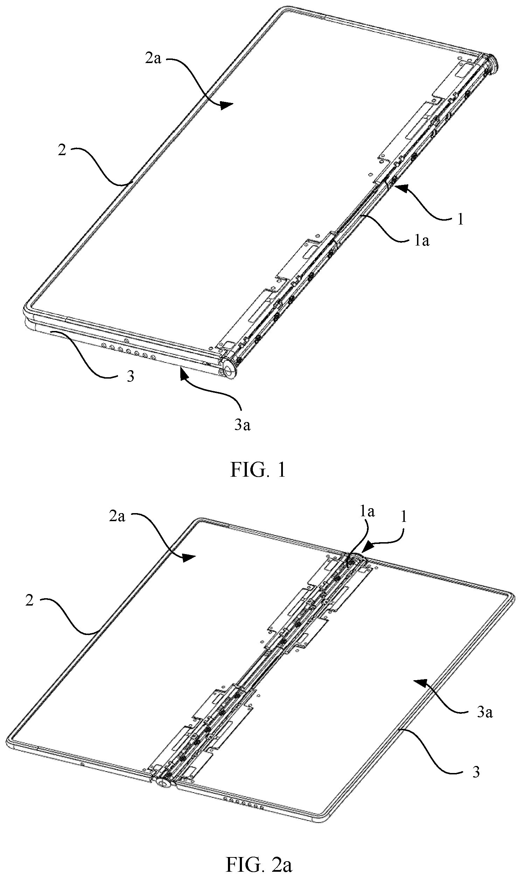

For ease of understanding a hinge mechanism provided in embodiments of this application, the following first describes an application scenario of the hinge mechanism. Use of the hinge mechanism may be in, but is not limited to, a foldable electronic device like a mobile phone, a palmtop computer (personal digital assistant, PDA), a notebook computer, or a tablet computer. In this application, the electronic device may be an outward folding electronic device, or may be an inward folding electronic device. In a process in which the outward folding electronic device changes from an unfolded state to a folded state, a flexible display is always located on an outer side of the electronic device. When the inward folding electronic device is in a folded state, a flexible display is located on an inner side of the electronic device. In embodiments of this application, application of the hinge mechanism in the electronic device is described by using the outward folding electronic device as an example. FIG. 1 is a diagram of a structure of an electronic device in a folded state according to an embodiment of this application. In addition to a hinge mechanism 1, the electronic device may further include two housings and a flexible display. For ease of description, the two housings may be respectively named a first housing 2 and a second housing 3. The first housing 2 and the second housing 3 are located on two sides of the hinge mechanism 1, and can rotate around the hinge mechanism 1. When the electronic device is used, the electronic device may be folded or unfolded in different use scenarios.

FIG. 1 shows a relative position relationship between the hinge mechanism 1 and the two housings when the electronic device is in a folded state. In this case, a first surface of the hinge mechanism 1, a first surface of the first housing, and a first surface of the second housing may be jointly used as a support surface of the flexible display (not shown in FIG. 1). The flexible display is omitted in FIG. 1. The first surface of the hinge mechanism 1 is a surface that is of the hinge mechanism 1 and that faces the flexible display. The first surface of the first housing 2 is a surface that is of the first housing 2 and that faces the flexible display. The first surface of the second housing 3 is a surface that is of the second housing 3 and that faces the flexible display. For ease of description, in this application, the first surface of the hinge mechanism 1 may be defined as a bearing surface 1a of the hinge mechanism 1, the first surface of the first housing 2 may be defined as a first support surface 2a, and the first surface of the second housing 3 may be defined as a second support surface 3a.

FIG. 2a is a diagram of a structure of an electronic device in an unfolded state, and FIG. 2a shows a structure of the first support surface 2a of the first housing 2 and a structure of the second support surface 3a of the second housing 3. In the unfolded state, the bearing surface 1a of the hinge mechanism 1, the first support surface 2a of the first housing 2, and the second support surface 3a of the second housing 3 may be connected to form a flat support surface.

In view of this, the flexible display may continuously cover the bearing surface 1a of the hinge mechanism 1, the first support surface 2a of the first housing 2, and the second support surface 3a of the second housing 3. The hinge mechanism 1 is disposed corresponding to a bendable part of the flexible display, and the flexible display may be fixedly connected to the first support surface 2a of the first housing 2 and the second support surface 3a of the second housing 3. A connection manner of the flexible display may be but is not limited to bonding. In this way, when the electronic device is in the unfolded state shown in FIG. 2a, the hinge mechanism 1, the first housing 2, and the second housing 3 may flatly support the flexible display.

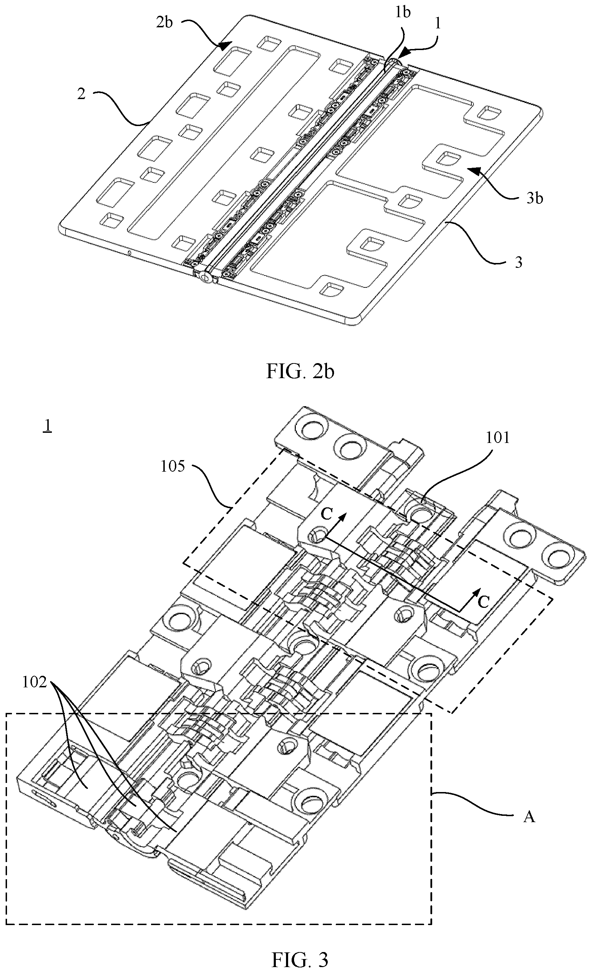

In addition, FIG. 2b is a diagram of another structure of an electronic device in an unfolded state according to an embodiment of this application. FIG. 2b shows structures of a second surface of the hinge mechanism 1, a second surface of the first housing 2, and a second surface of the second housing 3. The second surface of the hinge mechanism 1 is a surface that is of the hinge mechanism 1 and that is away from the flexible display, the second surface of the first housing 2 is a surface that is of the first housing 2 and that is away from the flexible display, and the second surface of the second housing 3 is a surface that is of the second housing 3 and that is away from the flexible display. In this case, the first surface and the second surface of the hinge mechanism 1 are disposed opposite to each other, the first surface and the second surface of the first housing 2 are disposed opposite to each other, and the first surface and the second surface of the second housing 3 are disposed opposite to each other. In this application, the second surface of the hinge mechanism 1, the second surface of the first housing 2, and the second surface of the second housing 3 may be used as an appearance surface of the electronic device. For ease of description, the second surface of the first housing 2 may be defined as a first appearance surface 2b, the second surface of the second housing 3 may be defined as a second appearance surface 3b, and the second surface of the hinge mechanism 1 may be defined as a third appearance surface 1b. It may be understood that, for the outward folding electronic device, the appearance surface of the electronic device is exposed outside the electronic device when the electronic device is in the unfolded state, and the appearance surface of the electronic device is located inside the electronic device when the electronic device is in the folded state. In this application, in a process in which the first housing 2 and the second housing 3 relatively rotate from the unfolded state shown in FIG. 2a or FIG. 2b to the folded state shown in FIG. 1 or from the folded state shown in FIG. 1 to the unfolded state shown in FIG. 2a or FIG. 2b, the flexible display may be bent or flattened with the first housing 2 and the second housing 3. In addition, it may be understood that a process in which the electronic device changes from the unfolded state shown in FIG. 2a or FIG. 2b to the folded state shown in FIG. 1 or from the folded state shown in FIG. 1 to the unfolded state shown in FIG. 2a or FIG. 2b is a process in which the first housing 2 and the second housing 3 rotate around the hinge mechanism 1.

The hinge mechanism 1 as a key functional component in the foldable electronic device may be disposed corresponding to a foldable part of the flexible display. In the process in which the first housing 2 and the second housing 3 of the electronic device rotate around the hinge mechanism 1, if forces applied by the first housing 2 and the second housing 3 to the flexible display are not synchronous, stress on the flexible display is likely to be nonuniform. Consequently, the flexible display is squeezed or pulled, or even the flexible display is damaged.

In view of this, a synchronization assembly is disposed in the hinge mechanism provided in this application, to help the first housing and the second housing of the electronic device synchronously move toward each other or away from each other around the hinge mechanism, so that a part that is of the flexible display and that is connected to the first housing and a part that is of the flexible display and that is connected to the second housing can synchronously move toward each other or away from each other. This can improve uniformity of the stress on the flexible display, and effectively reduce a risk that the flexible display is squeezed or pulled, to prolong a service life of the flexible display, and further improve structural reliability of the electronic device. To facilitate understanding of the hinge mechanism provided in embodiments of this application, the following describes a specific structure of the hinge mechanism in detail with reference to the accompanying drawings.

FIG. 3 is a diagram of a structure of the hinge mechanism 1 according to an embodiment of this application. In this application, the hinge mechanism 1 may include a main shaft 101 and a synchronization assembly 102. A quantity of synchronization assemblies 102 in the hinge mechanism 1 is not limited in this application. The hinge mechanism 1 may include only one synchronization assembly 102, or may include a plurality of synchronization assemblies 102. When the hinge mechanism 1 includes a plurality of synchronization assemblies 102, the plurality of synchronization assemblies 102 may be arranged at spacings along a length direction of the hinge mechanism 1. In this application, the length direction of the hinge mechanism 1 is an extension direction of an axis along which the first housing 2 and the second housing 3 rotate around the hinge mechanism 1 shown in FIG. 2b.

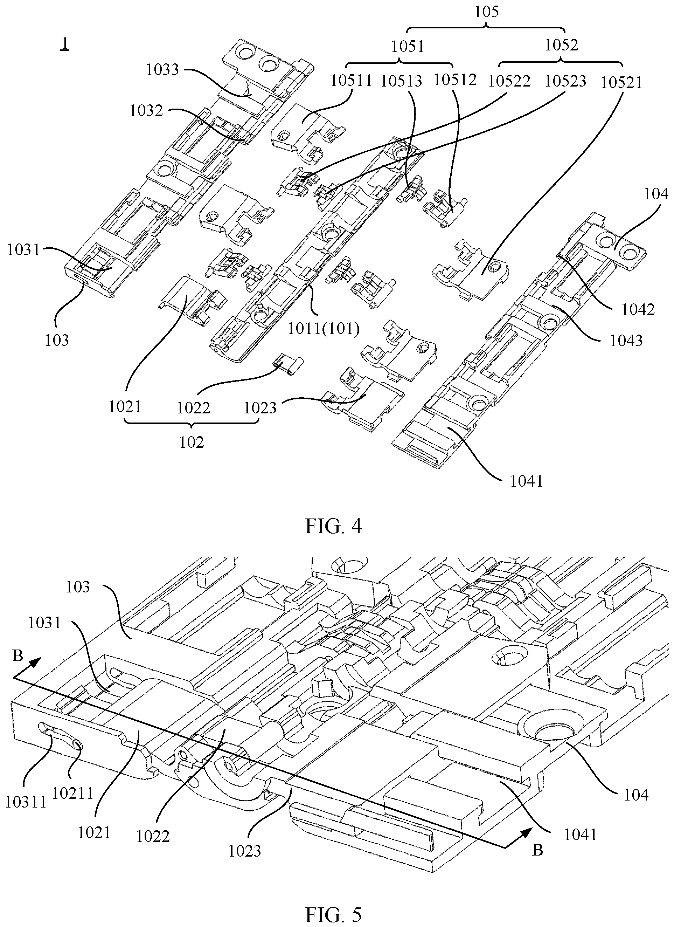

In this application, refer to FIG. 4 about how to set the synchronization assembly 102. FIG. 4 is an exploded view of the hinge mechanism 1 shown in FIG. 3. The synchronization assembly 102 may include a first connecting rod 1021, a second connecting rod 1022, and a third connecting rod 1023. In addition, FIG. 5 is an enlarged view of a partial structure at an A position of the hinge mechanism 1 shown in FIG. 3. The second connecting rod 1022 is located between the first connecting rod 1021 and the third connecting rod 1023, the second connecting rod 1022 is rotatably connected to the first connecting rod 1021, the second connecting rod 1022 is rotatably connected to the third connecting rod 1023, and an axis along which the second connecting rod 1022 is rotatably connected to the first connecting rod 1021 is parallel to and does not coincide with an axis along which the second connecting rod 1022 is rotatably connected to the third connecting rod 1023.

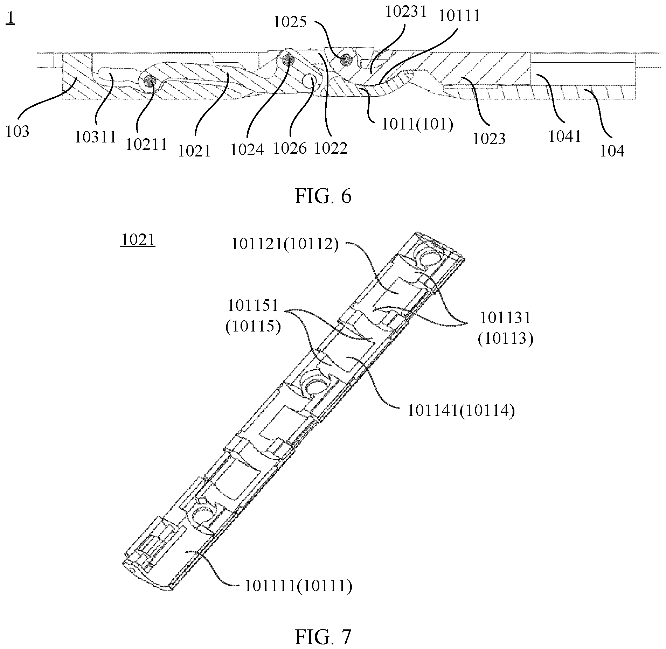

FIG. 6 is a B-B sectional view of the hinge mechanism 1 shown in FIG. 5. The first connecting rod 1021 is further rotatably connected to the main shaft 101. In this application, an axis along which the first connecting rod 1021 rotates around the main shaft 101 is parallel to and does not coincide with the axis in which the second connecting rod 1022 is rotatably connected to the first connecting rod 1021. In this application, for ease of description, a rotating shaft for the rotatable connection between the first connecting rod 1021 and the second connecting rod 1022 may be defined as a first shaft 1024, a rotating shaft for the rotatable connection between the second connecting rod 1022 and the third connecting rod 1023 may be defined as a second shaft 1025, and a rotating shaft for the rotatable connection between the first connecting rod 1021 and the main shaft 101 may be defined as a third shaft 1026. In this case, axes of the first shaft 1024, the second shaft 1025, and the third shaft 1026 are parallel to each other and do not coincide with each other. In this way, a four-link mechanism may be formed among the first connecting rod 1021, the main shaft 101, the second connecting rod 1022, and the third connecting rod 1023.

Refer to FIG. 5 and FIG. 6 together. The third connecting rod 1023 is rotatably connected to the main shaft 101. In this application, a manner of the rotatable connection between the third connecting rod 1023 and the main shaft 101 is not limited. For example, the third connecting rod 1023 may be rotatably connected to the main shaft 101 via a virtual shaft. This can help reduce space occupied by the third connecting rod 1023 on the main shaft 101, to help reduce a volume of a rotating module 105, and implement a compact design for the hinge mechanism 1. In addition, it may be understood that, for the outward folding electronic device, when the third connecting rod 1023 is rotatably connected to the main shaft 101 in a virtual shaft manner, an axis center at which the third connecting rod 1023 rotates around the main shaft 101 is located on a side that is of the main shaft 101 and that is away from the flexible display.

It should be noted that, in this application, the virtual shaft is an axis center of a circular-arc-shaped structure. Two components that are rotatably connected are capable of rotating relative to the virtual shaft, and a position of the virtual shaft is fixed as the two components that are rotatably connected rotate relative to each other. For example, as shown in FIG. 6, the main shaft 101 includes a base 1011. FIG. 7 is a diagram of a partial structure of the base 1011 according to an embodiment of this application. The base 1011 is provided with a first arc-shaped slot 10111. Refer to FIG. 6 and FIG. 7. The third connecting rod 1023 includes a first arc-shaped rotating block 10231, the first arc-shaped rotating block 10231 is accommodated in the first arc-shaped slot 10111, and the first arc-shaped rotating block 10231 is capable of sliding along a slot surface 101111 of the first arc-shaped slot. In this way, the rotation of the third connecting rod 1023 around the base 1011 is implemented through sliding of the first arc-shaped rotating block 10231 along the slot surface 101111 of the first arc-shaped slot. In addition, in this application, the first arc-shaped rotating block 10231 may be but is not limited to a circular-arc-shaped rotating block, and the first arc-shaped slot 10111 may be but is not limited to a circular-arc-shaped slot. It may be understood that, when the first arc-shaped rotating block 10231 is a circular-arc-shaped rotating block, a surface that is of the first arc-shaped rotating block 10231 and that is in contact with the slot surface 101111 of the first arc-shaped slot may be a circular arc surface, the slot surface 101111 of the first arc-shaped slot is also a circular arc surface, and centers of the two circular arc surfaces coincide with each other.

Refer to FIG. 5 and FIG. 6 together. In this application, a mechanism of the main shaft 101 may further include a first housing mounting bracket 103 and a second housing mounting bracket 104. The first housing mounting bracket 103 and the second housing mounting bracket 104 are respectively disposed on two opposite sides of the main shaft 101. The first connecting rod 1021 and the first housing mounting bracket 103 are located on a same side of the main shaft 101, and the first connecting rod 1021 may be slidably connected to the first housing mounting bracket 103. Refer to FIG. 5 and FIG. 6 together. The first housing mounting bracket 103 may be provided with a first track slot 10311, and the first connecting rod 1021 is capable of sliding along the first track slot 10311. During specific implementation, as shown in FIG. 5, the first housing mounting bracket 103 has a guide part 1031, and the guide part 1031 may be set as an accommodation slot. In this way, the guide part 1031 may include two oppositely disposed slot walls along an extension direction of an axis along which the first housing mounting bracket 103 rotates around the main shaft 101, and the two slot walls may be separately provided with one first track slot 10311.

The first connecting rod 1021 is mounted on the guide part 1031. In addition, the first connecting rod 1021 may be provided with one guide structure 10211 corresponding to each first track slot 10311. The guide structure 10211 is inserted into the first track slot 10311. In a process in which the electronic device changes from an unfolded state to a folded state or from a folded state to an unfolded state, the guide structure 10211 is capable of sliding along the first track slot 10311. In this application, a specific structure of the guide structure 10211 is not limited. For example, the guide structure 10211 may be a pin that penetrates the first connecting rod 1021, and each of two end parts of the pin may be correspondingly inserted into one first track slot 10311.

Still refer to FIG. 6. The third connecting rod 1023 and the second housing mounting bracket 104 are located on a same side of the base 1011, and the third connecting rod 1023 is slidably connected to the second housing mounting bracket 104. During specific implementation, the second housing mounting bracket 104 is provided with a first sliding groove 1041, the first sliding groove 1041 extends along a first direction, the third connecting rod 1023 may be mounted in the first sliding groove 1041, and in the process in which the electronic device changes from the unfolded state to the folded state or from the folded state to the unfolded state, the third connecting rod 1023 is capable of sliding in the first sliding groove 1041, toward or away from the base 1011, and relative to the second housing mounting bracket 104. In addition, to prevent the third connecting rod 1023 from falling off from the first sliding groove 1041, a first sliding rail may be disposed on a sliding groove wall of the first sliding groove 1041, and a first sliding block may be disposed on the third connecting rod 1023. In this way, the first sliding block may be clamped on the first sliding rail, and the first sliding block is capable of sliding along the first sliding rail, to limit the third connecting rod 1023 to the first sliding groove 1041. In addition, the first sliding rail is disposed on the sliding groove wall of the first sliding groove 1041, which may provide guidance for sliding of the third connecting rod 1023 along the first sliding groove 1041, to improve movement stability of the third connecting rod 1023.

In this application, a specific disposing form of the first sliding groove 1041 is not limited. For example, the first sliding groove 1041 may be a straight-line sliding groove. In this case, the first sliding block may be provided with a straight-line sliding block structure, which can effectively simplify a connection structure between the third connecting rod 1023 and the second housing mounting bracket 104, and improve smoothness of sliding of the third connecting rod 1023 relative to the second housing mounting bracket 104.

Based on the foregoing descriptions of the structure of the hinge mechanism 1 provided in this application, in this application, a form of the first track slot 10311 may be obtained through fitting based on processes in which the first housing mounting bracket 103 and the second housing mounting bracket 104 synchronously move toward each other and away from each other relative to the main shaft 101, so that the first connecting rod 1021 is capable of sliding along the first track slot 10311. In this way, the first housing mounting bracket 103 and the second housing mounting bracket 104 synchronously rotate toward each other or away from each other relative to the main shaft 101.

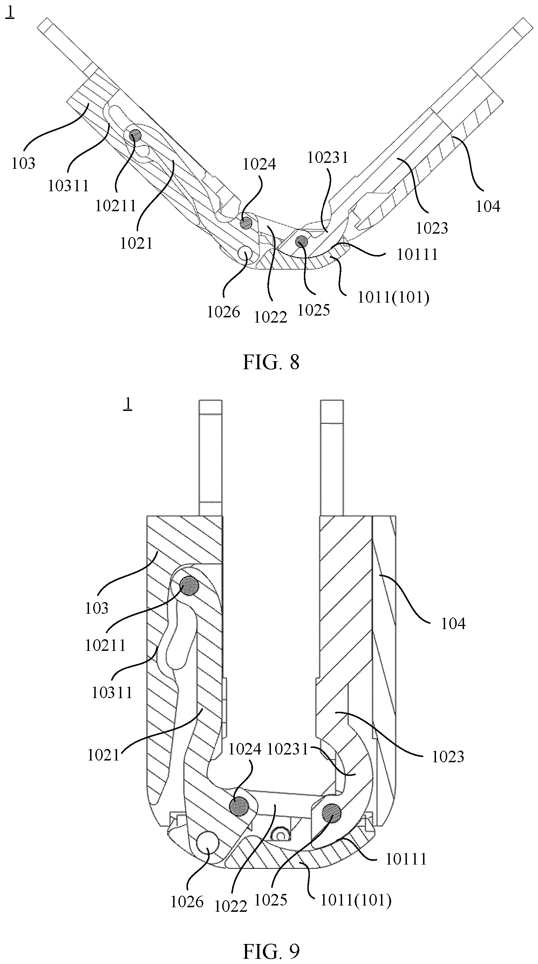

FIG. 8 is a diagram of a structure of the hinge mechanism 1 shown in FIG. 6 when the electronic device is in an intermediate state. In this case, in a folding process in which the electronic device changes from the unfolded state to the folded state, the first housing mounting bracket 103 rotates clockwise relative to the main shaft 101, so that the first connecting rod 1021 slides along the first track slot 10311 toward an end part that is of the first track slot 10311 and that is away from the main shaft 101, and the first connecting rod 1021 rotates around the main shaft 101. The rotation of the first connecting rod 1021 may drive the second connecting rod 1022 to rotate relative to the first connecting rod 1021, so that the second connecting rod 1022 drives the third connecting rod 1023 to rotate relative to the main shaft 101. In a process in which the first connecting rod 1021 rotates around the main shaft 101, the first shaft 1024 is driven to move away from the main shaft 101. In this case, the second shaft 1025 may move toward the main shaft 101, so that the third connecting rod 1023 may be driven to rotate counter-clockwise relative to the main shaft 101. In addition, because the third connecting rod 1023 is slidably connected to the second housing mounting bracket 104, the third connecting rod 1023 may drive the second housing mounting bracket 104 to rotate counter-clockwise, so that the first housing mounting bracket 103 and the second housing mounting bracket 104 synchronously rotate toward each other.

FIG. 9 is a diagram of a structure of the hinge mechanism 1 shown in FIG. 8 when the electronic device is in the folded state. In a folding process in which the electronic device changes from the intermediate state to the folded state, the first housing mounting bracket 103 continues to rotate clockwise relative to the main shaft 101, and drives, by using the synchronization assembly 102, the second housing mounting bracket 104 to continue to rotate counter-clockwise relative to the main shaft 101 until the electronic device is in the folded state. In addition, in the process in which the electronic device changes from the folded state to the unfolded state, a movement direction of each structure is opposite to a movement direction of each structure in the process in which the electronic device changes from the unfolded state to the folded state. Details are not described herein. In this case, the first housing mounting bracket 103 and the second housing mounting bracket 104 synchronously move away from each other.

In the hinge mechanism 1 provided in embodiments of this application, the first connecting rod 1021 is rotatably connected to the main shaft 101 and the second connecting rod 1022, the second connecting rod 1022 is rotatably connected to the third connecting rod 1023, and axes of the rotating shafts are parallel to each other and do not coincide with each other, so that the first connecting rod 1021, the main shaft 101, the second connecting rod 1022, and the third connecting rod 1023 can be connected to form the four-link mechanism. A structure of the four-link mechanism is relatively simple, so that the synchronization assembly 102 occupies small space in the hinge mechanism 1 while the first housing mounting bracket 103 and the second housing mounting bracket 104 can synchronously rotate toward each other or away from each other, to help implement a compact design for the hinge mechanism 1.

The hinge mechanism 1 provided in the foregoing embodiments of this application may be used in, for example, the outward folding electronic device shown in FIG. 1 or FIG. 2a. The first housing mounting bracket 103 may be fastened to a housing located on a same side of the main shaft 101, and the second housing mounting bracket 104 may be fastened to another housing. For example, the first housing mounting bracket 103 may be configured to be fastened to the first housing 2 of the electronic device shown in FIG. 2a, and the second housing mounting bracket 104 may be configured to be fastened to the second housing 3 of the electronic device shown in FIG. 2a. In view of this, it may be understood that, a process in which the first housing mounting bracket 103 and the second housing mounting bracket 104 synchronously rotate toward each other or away from each other is a process in which the first housing 2 and the second housing 3 synchronously rotate toward each other or away from each other.

In addition, the flexible display of the electronic device may be fastened to the first housing 2 and the second housing 3, and a connection manner may be but is not limited to bonding. During specific implementation, the flexible display may be bonded to a part of the first support surface 2a of the first housing 2, and the flexible display may be bonded to a part of the second support surface 3a of the second housing 3. In this way, when the electronic device is in the unfolded state, the bearing surface 1a of the hinge mechanism 1, the first support surface 2a of the first housing 2, and the second support surface 3a of the second housing 3 may jointly flatly support the flexible display. Therefore, it can be ensured that a form of the electronic device in the unfolded state is complete. In the process in which the electronic device changes from the unfolded state to the folded state, synchronous rotation of the two housings may drive synchronous rotation of parts that are of the flexible display and that are fastened to the two housings, so that the stress on the flexible display is relatively uniform, to effectively avoid deformation of the flexible display, and reduce a risk of damage to the flexible display.

In this application, to implement a rotation function of the hinge mechanism 1, the hinge mechanism 1 may further include a rotating module 105. A quantity of rotating modules 105 in the hinge mechanism 1 is not limited in this application. The hinge mechanism 1 may include only one rotating module 105, or may include a plurality of rotating modules 105. Still refer to FIG. 3. When the hinge mechanism 1 includes a plurality of rotating modules 105, the plurality of rotating modules 105 may be arranged at spacings along a length direction of the hinge mechanism 1.

For ease of understanding a structure of the rotating module 105, still refer to FIG. 4. The rotating module 105 may include a first rotating assembly 1051 and a second rotating assembly 1052, where the first rotating assembly 1051 is located between the first housing mounting bracket 103 and the second housing mounting bracket 104, and the second rotating assembly 1052 is located between the first housing mounting bracket 103 and the second housing mounting bracket 104. In addition, as shown in FIG. 4, the main shaft 101 of the hinge mechanism 1 may be used as a bearing component of the first rotating assembly 1051 and the second rotating assembly 1052.

It should be noted that, in embodiments of this application, when there are a plurality of rotating modules 105, first rotating assemblies 1051 and second rotating assemblies 1052 of the plurality of rotating modules 105 may all use the same main shaft 101 as the bearing component, to improve an integration degree of the hinge mechanism 1. In some other possible embodiments of this application, one main shaft 101 may be correspondingly disposed for each rotating module 105 in the hinge mechanism 1, so that a corresponding main shaft 101 is used as a bearing component for a first rotating assembly 1051 and a second rotating assembly 1052 of each rotating module 105.

Still refer to FIG. 4. The first rotating assembly 1051 may include a first swing arm 10511, a first support arm 10512, and a first connector 10513. The first connector 10513 is located between the first swing arm 10511 and the first support arm 10512, the first connector 10513 is rotatably connected to the first swing arm 10511, and the first connector 10513 is rotatably connected to the first support arm 10512, so that the first swing arm 10511 and the first support arm 10512 perform mutual pulling movement via the first connector 10513. In view of this, it may be understood that a movement track of the first connector 10513 plays a key role in a movement track of the first rotating assembly 1051.

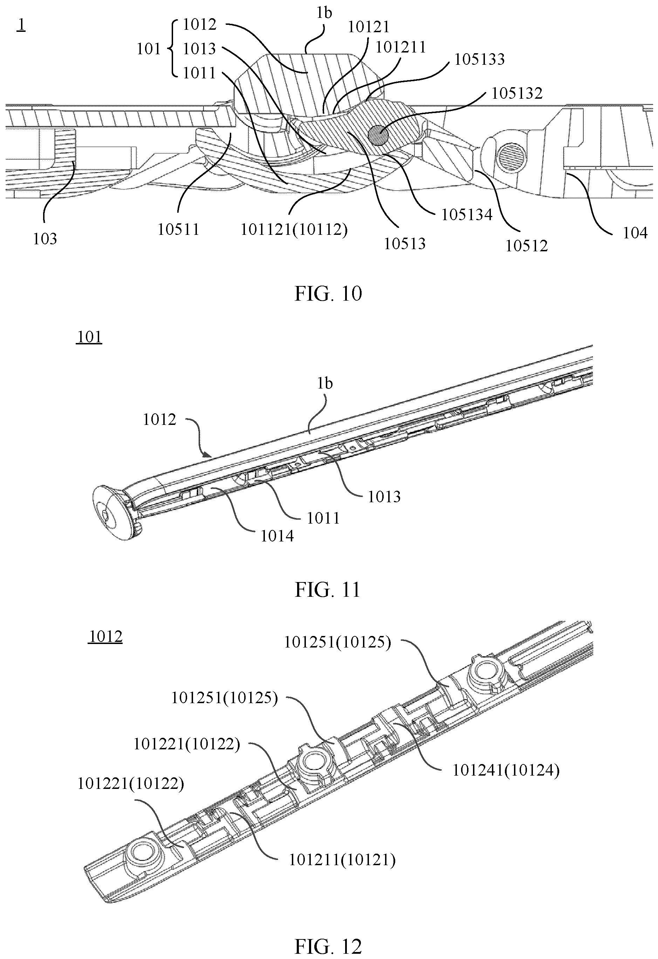

In this application, the first connector 10513 is capable of moving relative to the main shaft 101. In practice, refer to FIG. 10. FIG. 10 is a sectional view of the first connector 10513 of the hinge mechanism 1 when the electronic device is in the unfolded state according to an embodiment of this application. The main shaft 101 may be provided with a second track slot 1013, and the first connector 10513 is capable of moving along the second track slot 1013, for limitation on a movement track of the first connector 10513.

FIG. 11 is a diagram of a structure of the main shaft 101 according to this application. The main shaft 101 may further include a cover 1012. The cover 1012 covers the base 1011, and an outer surface of the cover 1012 may be used as the third appearance surface 1b of the hinge mechanism 1. As shown in FIG. 7, the base 1011 may be provided with a second arc-shaped slot 10112. Refer to FIG. 7 and FIG. 10 together. The first connector 10513 is accommodated in the second arc-shaped slot 10112, and the first connector 10513 is capable of sliding along a slot surface 101121 of the second arc-shaped slot. In addition, refer to FIG. 12. FIG. 12 is a diagram of a structure of the cover 1012 of the main shaft 101 shown in FIG. 11. FIG. 12 is used to show a structure of a side that is of the cover 1012 and that faces the base 1011. The cover 1012 includes a first protrusion 10121. The first protrusion 10121 may be disposed toward the second arc-shaped slot 10112. A gap exists between a surface 101211 of the first protrusion and the slot surface 101121 of the second arc-shaped slot, and the gap is used as the second track slot 1013.

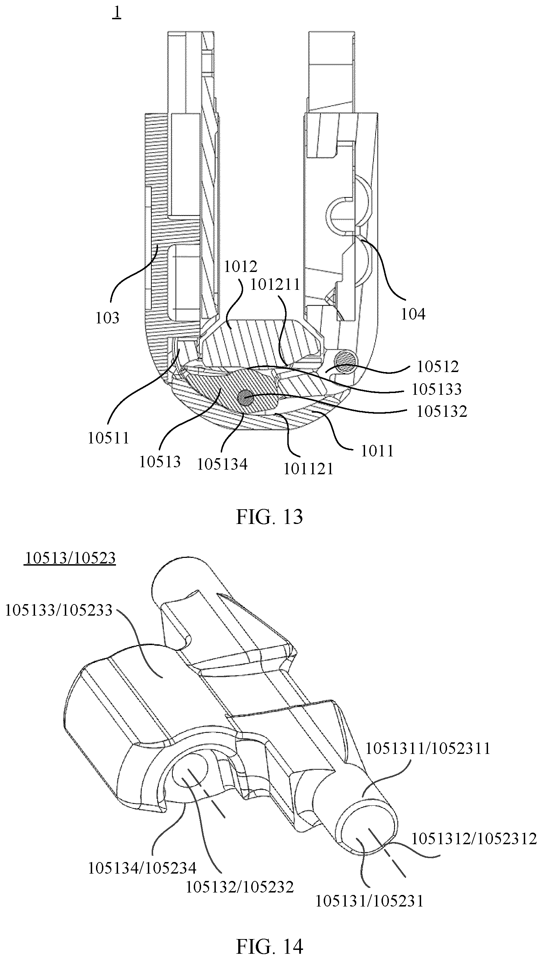

FIG. 13 is a sectional view of the first connector 10513 of the hinge mechanism 1 when the electronic device is in the folded state according to an embodiment of this application. Refer to FIG. 12 and FIG. 13 together. In the process in which the electronic device changes from the unfolded state to the folded state, the first connector 10513 is capable of moving toward the first swing arm 10511 in the second track slot 1013. In the process in which the electronic device changes from the folded state to the unfolded state, the first connector 10513 is capable of moving toward the first support arm 10512 in the second track slot 1013. In this way, the first connector 10513 is capable of moving relative to the main shaft 101 according to a specified track.

Refer to FIG. 12 and FIG. 13 together. It can be seen that, in the process in which the electronic device changes from the unfolded state to the folded state or from the folded state to the unfolded state, the first swing arm 10511 and the first support arm 10512 can rotate around the main shaft 101. In addition, because the first swing arm 10511 and the first support arm 10512 perform mutual pulling movement via the first connector 10513, the first connector 10513 can further rotate relative to the surface 101211 of the first protrusion and the slot surface 101121 of the second arc-shaped slot in a process in which the first connector 10513 moves in the second track slot 1013, to improve smoothness of movement of the first rotating assembly 1051.

FIG. 14 is a diagram of a structure of the first connector 10513 according to an embodiment of this application. In this application, the first connector 10513 may include a first arc-shaped surface 105133 and a second arc-shaped surface 105134. To implement rotation of the first connector 10513 relative to the surface 101211 of the first protrusion and the slot surface 101121 of the second arc-shaped slot, the first arc-shaped surface 105133 and the second arc-shaped surface 105134 may be circular arc surfaces, and a center of the first arc-shaped surface 105133 coincides with a center of the second arc-shaped surface 105134. Radii of the first arc-shaped surface 105133 and the second arc-shaped surface 105134 may be equal or unequal, which is not limited in this application. In addition, considering design tolerance, the first arc-shaped surface 105133 and the second arc-shaped surface 105134 may also be arc surfaces of other possible forms such as an elliptical arc surface, provided that the first connector 10513 can rotate relative to the surface 101211 of the first protrusion and the slot surface 101121 of the second arc-shaped slot.

Still refer to FIG. 12 and FIG. 13. When the electronic device is in the unfolded state shown in FIG. 12 and the folded state shown in FIG. 13, the first arc-shaped surface 105133 of the first connector 10513 may abut against the surface 101211 of the first protrusion, and the second arc-shaped surface 105134 abuts against the slot surface 101121 of the second arc-shaped slot. In this way, the surface 101211 of the first protrusion and the slot surface 101121 of the second arc-shaped slot limit the first connector 10513 to the second track slot 1013, so that when the hinge mechanism 1 is in the unfolded state and the folded state, the first connector 10513 is relatively stable without any gap-caused shake, and reliability of the hinge mechanism 1 is improved in the foregoing two states.

In this application, when the electronic device is in the unfolded state shown in FIG. 12, a distance between a point at which the surface 101211 of the first protrusion abuts against the first arc-shaped surface 105133 and a point at which the slot surface 101121 of the second arc-shaped slot abuts against the second arc-shaped surface 105134 may be denoted as d1. When the electronic device is in the folded state shown in FIG. 13, a distance between a point at which the surface 101211 of the first protrusion abuts against the first arc-shaped surface 105133 and a point at which the slot surface 101121 of the second arc-shaped slot abuts against the second arc-shaped surface 105134 is denoted as d2. When the electronic device is in the unfolded state and the folded state, the first arc-shaped surface 105133 of the first connector 10513 may abut against the surface 101211 of the first protrusion, and the second arc-shaped surface 105134 abuts against the slot surface 101121 of the second arc-shaped slot. Therefore, when both the first arc-shaped surface 105133 and the second arc-shaped surface 105134 are circular arc surfaces, d1 = d2 may be obtained.

In this application, specific disposing forms of the surface 101211 of the first protrusion and the slot surface 101121 of the second arc-shaped slot are not limited. For example, the surface 101211 of the first protrusion may be a circular arc surface, and the slot surface 101121 of the second arc-shaped slot may be a circular arc surface. In addition, a circle center of the surface 101211 of the first protrusion coincides with a circle center of the slot surface 101121 of the second arc-shaped slot. In some other possible embodiments of this application, both the surface 101211 of the first protrusion and the slot surface 101121 of the second arc-shaped slot may be configured as planes, so that the second track slot 1013 is a straight line slot. Alternatively, both the surface 101211 of the first protrusion and the slot surface 101121 of the second arc-shaped slot may be curved surfaces in other forms, so that the second track slot 1013 is a curved slot in any form, which should be understood as falling within the protection scope of this application.

Still refer to FIG. 12. In this application, the surface 101211 of the first protrusion may be equidistant from the slot surface 101121 of the second arc-shaped slot, and in this case, the second track slot 1013 is an equal-width slot. In the processes in which the electronic device changes from the unfolded state to the folded state and from the folded state to the unfolded state, the surface 101211 of the first protrusion keeps an abut-against state with the first arc-shaped surface 105133, and the slot surface 101121 of the second arc-shaped slot keeps an abut-against state with the second arc-shaped surface 105134. Therefore, in the processes in which the electronic device changes from the unfolded state to the folded state and from the folded state to the unfolded state, movement trajectories of the first connector 10513 may be the same. This can help improve movement stability of the first connector 10513, to improve movement stability of the first rotating assembly 1051.

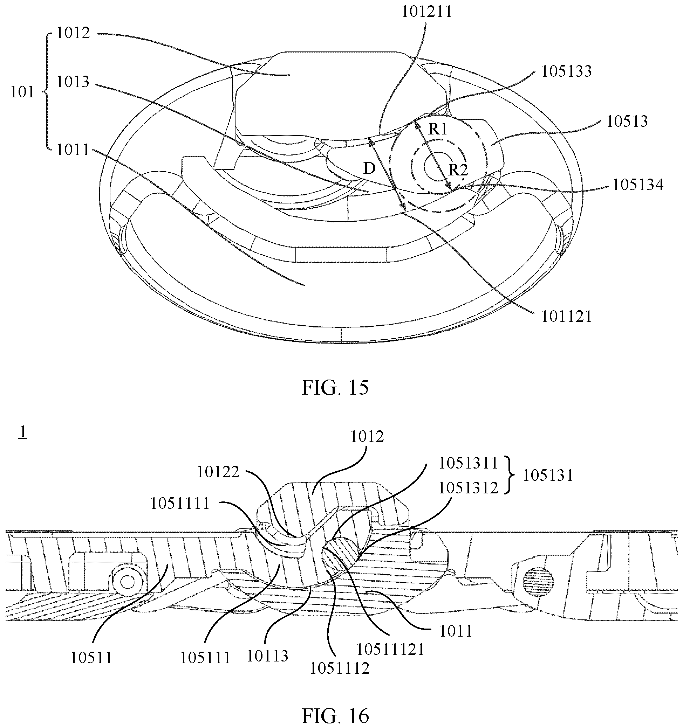

FIG. 15 is a diagram of an assembly structure of the first connector 10513 and the main shaft 101 according to an embodiment of this application. In this application, when the second track slot 1013 is an equal-width slot, and the first arc-shaped surface 105133 and the second arc-shaped surface 105134 are circular arc surfaces, a sum of a radius R1 of the first arc-shaped surface 105133 and a radius R2 of the second arc-shaped surface 105134 is equal to a spacing D between the surface 101211 of the first protrusion and the slot surface 101121 of the second arc-shaped slot. In addition, in consideration of smoothness of movement of the first connector 10513 in the second track slot 1013, a specific design gap may be reserved between the first arc-shaped surface 105133 and the surface 101211 of the first protrusion, and/or between the second arc-shaped surface 105134 and the slot surface 101121 of the second arc-shaped slot.

In some other possible embodiments of this application, a movement track of the first connector 10513 in the process in which the electronic device changes from the unfolded state to the folded state may be different from a movement track of the first connector 10513 in the process in which the electronic device changes from the folded state to the unfolded state. During specific implementation, in the process in which the electronic device changes from the unfolded state to the folded state, the first arc-shaped surface 105133 abuts against the surface 101211 of the first protrusion, and there is a gap between the second arc-shaped surface 105134 and the slot surface 101121 of the second arc-shaped slot. In addition, in the process in which the electronic device changes from the unfolded state to the folded state, the second arc-shaped surface 105134 abuts against the slot surface 101121 of the second arc-shaped slot, and there is a gap between the first arc-shaped surface 105133 and the surface 101211 of the first protrusion. In this embodiment, the surface 101211 of the first protrusion may be non-equidistant from the slot surface 101121 of the second arc-shaped slot, and in this case, the second track slot 1013 may be a non-equal-width slot.

It can be learned from the foregoing descriptions that, in this application, the first swing arm 10511 may be rotatably connected to the main shaft 101, and the first swing arm 10511 may be rotatably connected to the main shaft 101 in a virtual shaft manner. This can help reduce space occupied by the first swing arm 10511 on the main shaft 101, to help reduce a volume of the rotating module 105, and implement a compact design for the hinge mechanism 1. In addition, it may be understood that, for the outward folding electronic device, when the first swing arm 10511 is rotatably connected to the main shaft 101 in a virtual shaft manner, an axis center at which the first swing arm 10511 rotates around the main shaft 101 is located on one side that is of the main shaft 101 and that is away from the flexible display.

FIG. 16 is a C-C sectional view of the hinge mechanism 1 shown in FIG. 3. A second arc-shaped rotating block 105111 may be disposed at an end that is of the first swing arm 10511 and that faces the base 1011. In addition, refer to FIG. 7. The base 1011 may be provided with a third arc-shaped slot 10113. The second arc-shaped rotating block 105111 may be accommodated in the third arc-shaped slot 10113, and the second arc-shaped rotating block 105111 is capable of sliding along the slot surface of the third arc-shaped slot 10113. In this way, the rotation of the first swing arm 10511 around the main shaft 101 is implemented through sliding of the second arc-shaped rotating block 105111 along the slot surface of the third arc-shaped slot 10113. In addition, in this application, the second arc-shaped rotating block 105111 may be but is not limited to a circular-arc-shaped rotating block, and the third arc-shaped slot 10113 may be but is not limited to a circular-arc-shaped slot. It may be understood that, when the second arc-shaped rotating block 105111 is a circular-arc-shaped rotating block, a surface that is of the second arc-shaped rotating block 105111 and that is in contact with the slot surface of the third arc-shaped slot 10113 may be a circular arc surface, the slot surface of the third arc-shaped slot 10113 is also a circular arc surface, and centers of the two circular arc surfaces coincide with each other.

Refer to FIG. 12 and FIG. 16 together. The cover 1012 may include a second protrusion 10122 disposed toward the third arc-shaped slot 10113, at least a part of the second arc-shaped rotating block 105111 is located between the second protrusion 10122 and the third arc-shaped slot 10113, and the second arc-shaped rotating block 105111 may be in contact with a surface 101221 of the second protrusion. In this way, the second arc-shaped rotating block 105111 may be limited between the cover 1012 and the base 1011, and rotation stability of the second arc-shaped rotating block 105111 relative to the base 1011 can be effectively improved.

It should be noted that when the slot surface of the third arc-shaped slot 10113 is a circular arc surface, a part that is of the surface 101221 of the second protrusion and that is in contact with the second arc-shaped rotating block 105111 may also be a circular arc surface, and centers of the two circular arc surfaces coincide with each other. In addition, a surface that is of the second arc-shaped rotating block 105111 and that faces the second protrusion 10122 may be a plane or a circular arc surface, provided that the second arc-shaped rotating block 105111 can rotate relative to the second protrusion 10122.

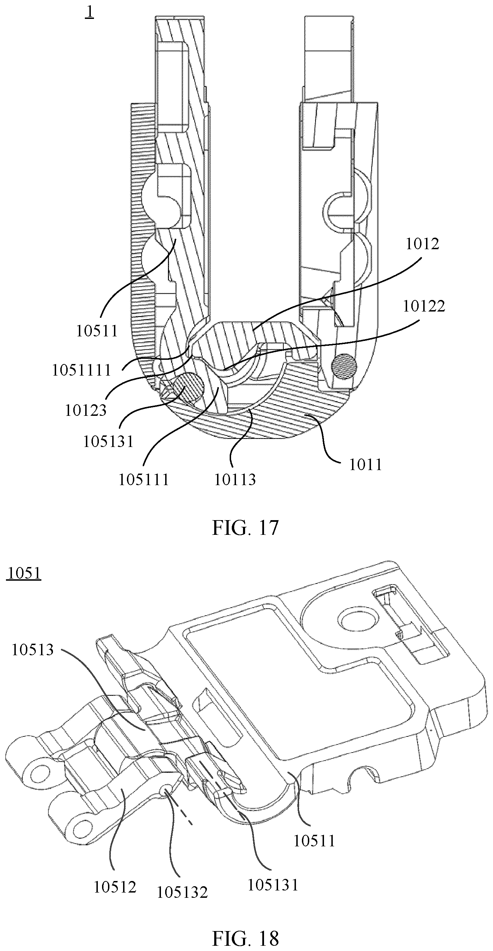

FIG. 17 is a sectional view of the first swing arm 10511 of the hinge mechanism 1 when the electronic device is in the folded state according to an embodiment of this application. In this application, the second arc-shaped rotating block 105111 may further be provided with a first recess 1051111, and an opening of the first recess 1051111 is disposed toward the cover 1012. In addition, a first insertion part 10123 may be disposed at an end part that is of the cover 1012 and that faces the first swing arm 10511. In this case, in the folded state, the first insertion part 10123 may be inserted into the first recess 1051111, and a surface that is of the first insertion part 10123 and that faces the third arc-shaped slot 10113 abuts against at least a part of a surface of the first recess 1051111. In this way, a rotation part of the second arc-shaped rotating block 105111 may be limited, and the second arc-shaped rotating block 105111 may be prevented from falling off from the third arc-shaped slot 10113, to improve reliability of a connection between the first swing arm 10511 and the main shaft 101, and improve structural reliability of the entire hinge mechanism 1.

It should be noted that, in this application, in addition to being rotatably connected to the main shaft 101 in a virtual shaft manner, the first swing arm 10511 may be rotatably connected to the main shaft 101 in a solid shaft manner, so that the first swing arm 10511 can be connected to the main shaft 101 relatively reliably. It may be understood that, when the first swing arm 10511 is connected to the main shaft 101 in a solid shaft manner, an axis center at which the first swing arm 10511 rotates around the main shaft 101 is also located on one side that is of the main shaft 101 and that is away from the flexible display.

In this application, when the first swing arm 10511 is rotatably connected to the first connector 10513, still refer to FIG. 14. The first connector 10513 may include a first rotating shaft 105131 and a second rotating shaft 105132, and an axis of the first rotating shaft 105131 is parallel to and does not coincide with an axis of the second rotating shaft 105132.

In addition, FIG. 18 is a diagram of a structure of the first rotating assembly 1051 according to an embodiment of this application. The first connector 10513 is rotatably connected to the first swing arm 10511 via the first rotating shaft 105131, and the first connector 10513 is rotatably connected to the first support arm 10512 via the second rotating shaft 105132. In this way, the first swing arm 10511 and the first support arm 10512 may perform mutual pulling movement via the first connector 10513.

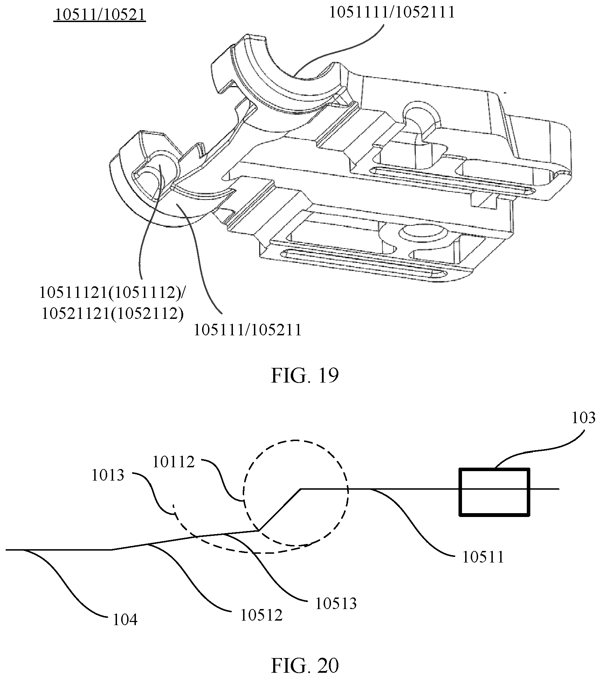

FIG. 19 is a diagram of a structure of the first swing arm 10511 according to an embodiment of this application. The second arc-shaped rotating block 105111 is provided with a first mounting slot 1051112. Refer to FIG. 16 and FIG. 19 together. A slot opening of the first mounting slot 1051112 is disposed toward the third arc-shaped slot 10113, and the first rotating shaft 105131 may be mounted in the first mounting slot 1051112. A part of a surface of the first rotating shaft 105131 may be in contact with a slot surface of the first mounting slot 1051112, and a part of the surface of the first rotating shaft 105131 is in contact with the slot surface of the third arc-shaped slot 10113, to limit the first rotating shaft 105131 to the first mounting slot 1051112.

Still refer to FIG. 16 and FIG. 19. The slot surface of the first mounting slot 1051112 may include a first circular arc surface 10511121, the surface that is of the first rotating shaft 105131 and that is in contact with the slot surface of the first mounting slot 1051112 is a second circular arc surface 1051311, and a center of the first circular arc surface 10511121 coincides with a center of the second circular arc surface 1051311. In addition, refer to FIG. 7. The slot surface of the third arc-shaped slot 10113 may be a third circular arc surface 101131. However, as shown in FIG. 16, the surface that is of the first rotating shaft 105131 and that is in contact with the slot surface of the third arc-shaped slot 10113 may be a fourth circular arc surface 1051312, and a center of the third circular arc surface 101131 coincides with a center of the fourth circular arc surface 1051312. In this way, refer to FIG. 16 and FIG. 17 together. When the first rotating shaft 105131 slides along the slot surface of the third arc-shaped slot 10113 with the second arc-shaped rotating block 105111, the first rotating shaft 105131 may further rotate relative to the second arc-shaped rotating block 105111, to help implement movement of the first connector 10513 relative to the main shaft 101.

In this application, when the first connector 10513 is rotatably connected to the first support arm 10512, as shown in FIG. 18, the second rotating shaft 105132 may penetrate both the first connector 10513 and the first support arm 10512. In this case, a connection manner of the first connector 10513 and the first support arm 10512 is relatively simple, which helps simplify a structure of the first rotating assembly 1051, so that a structure of the hinge mechanism 1 can be simplified. It should be noted that, when both the first arc-shaped surface 105133 and the second arc-shaped surface 105134 of the first connector 10513 are circular arc surfaces, the center of the first arc-shaped surface 105133, the center of the second arc-shaped surface 105134, and an axis center of the second rotating shaft 105132 coincide with each other.

It may be understood that, in the hinge mechanism 1 provided in embodiments of this application, the first connector 10513 may include a plurality of first sub-connectors that are sequentially rotatably connected. In addition, the plurality of first sub-connectors may be located between the first swing arm 10511 and the first support arm 10512. In this case, the first swing arm 10511 may be rotatably connected to a first sub-connector adjacent to the first swing arm 10511, and the first support arm 10512 may be rotatably connected to a first sub-connector adjacent to the first support arm 10512. For details, refer to the foregoing descriptions of the rotatable connection of the first swing arm 10511 and the first support arm 10512 to the first connector 10513. Details are not described herein. In this application, the first connector 10513 is set as the plurality of first sub-connectors that are sequentially rotatably connected, so that the first swing arm 10511 and the first support arm 10512 are connected via the plurality of first sub-connectors. This can effectively improve speed uniformity in a process in which the first swing arm 10511 and the first support arm 10512 rotate around the main shaft 101, thereby improving smoothness of mutual pulling movement of the first swing arm 10511 and the first support arm 10512.

Still refer to FIG. 4. In this application, the first swing arm 10511 may be further slidably connected to the first housing mounting bracket 103. During specific implementation, the first housing mounting bracket 103 is provided with a second sliding groove 1033. The second sliding groove 1033 extends along the first direction, and the first swing arm 10511 may be mounted in the second sliding groove 1033 and is capable of sliding along the first direction in the second sliding groove 1033. The first direction may be a direction along which the first housing mounting bracket 103 moves toward or away from the base 1011. In addition, to prevent the first swing arm 10511 from falling off from the second sliding groove 1033, a second sliding rail may be disposed on a sliding groove wall of the second sliding groove 1033, and a second sliding block may be disposed on the first swing arm 10511. In this way, the second sliding block may be clamped on the second sliding rail, and the second sliding block is capable of sliding along the second sliding rail, to limit the first swing arm 10511 to the second sliding groove 1033. In addition, the second sliding rail is disposed on the sliding groove wall of the second sliding groove 1033, which may provide guidance for sliding of the first swing arm 10511 along the second sliding groove 1033, to improve movement stability of the first swing arm 10511.

In this application, the first support arm 10512 may be rotatably connected to the second housing mounting bracket 104. During specific implementation, still refer to FIG. 4. The second housing mounting bracket 104 is provided with a second mounting part 1042. An end part that is of the first support arm 10512 and that faces the second housing mounting bracket 104 is mounted on the second mounting part 1042, and an end part that is of the first support arm 10512 and that faces the second housing mounting bracket 104 is rotatably connected to the second mounting part 1042.

In embodiments of this application, a specific manner in which the end part that is of the first support arm 10512 and that faces the second housing mounting bracket 104 is rotatably connected to the second mounting part 1042 is not limited. For example, still refer to FIG. 4. The second mounting part 1042 may be provided with a first mounting hole, and a second mounting hole is disposed at the end part that is of the first support arm 10512 and that faces the second housing mounting bracket 104. In this case, an end part that is of the first support arm 10512 and that faces the first housing mounting bracket 103 may be rotatably connected to the second mounting part 1042 via a rotating shaft that penetrates both the first mounting hole and the second mounting hole.

FIG. 20 is a diagram of a principle of a movement mechanism of the hinge mechanism 1 according to an embodiment of this application. Based on the hinge mechanism 1 provided in the foregoing embodiments of this application, in the process in which the electronic device changes from the unfolded state to the folded state, the first housing mounting bracket 103 and the second housing mounting bracket 104 move toward each other. When the first housing mounting bracket 103 drives the first swing arm 10511 to rotate around the main shaft 101 clockwise, the first swing arm 10511 is capable of sliding along the slot surface of the third arc-shaped slot 10113, so that the first connector 10513 may be driven to move toward the first swing arm 10511 in the second track slot 1013 of the main shaft 101. In addition, because the first connector 10513 is rotatably connected to the first support arm 10512, in a process in which the first connector 10513 moves toward the first swing arm 10511 in the second track slot 1013 of the main shaft 101, the first support arm 10512 may be driven to rotate around the main shaft 101 counter-clockwise, so that the first support arm 10512 drives the second housing mounting bracket 104 to rotate around the main shaft 101 counter-clockwise. In the process in which the electronic device changes from the folded state to the unfolded state, the first housing mounting bracket 103 and the second housing mounting bracket 104 move away from each other. When the first housing mounting bracket 103 drives the first swing arm 10511 to rotate around the main shaft 101 counter-clockwise, the first swing arm 10511 may drive the first connector 10513 to move toward the first support arm 10512 in the second track slot 1013 of the main shaft 101, and the first support arm 10512 may be driven to rotate around the main shaft 101 clockwise, so that the first support arm 10512 drives the second housing mounting bracket 104 to rotate around the main shaft 101 clockwise. In this way, folding and unfolding functions of the hinge mechanism 1 are implemented.

Some existing hinge mechanisms need to thicken a rotating assembly connected to a main shaft to ensure stability of the mechanisms. In this way, both the main shaft and the hinge mechanism are very heavy. If the main shaft and the hinge mechanism are forcibly thinned, strength of the rotating assembly is easily weakened, thereby greatly affecting reliability of the hinge mechanisms and shortening a life of the electronic device. The hinge mechanism 1 in this application has a simplified structure. According to the foregoing structural relationship, the first connector 10513 may be manufactured with a relatively small cross section to travel back and forth in the second track slot 1013 of the main shaft 101. In addition, the first connector 10513 has a sufficient length extension along a vertical axial direction, and separately has a connection relationship with the first swing arm 10511 and the first support arm 10512, so that reliability of the hinge mechanism 1 can be ensured. In this way, the thickness of the main shaft 101 and the thickness of the entire electronic device can be reduced, and reliability of the hinge mechanism 1 can be maintained, so that the entire hinge mechanism 1 is light, thin, and reliable.

In addition, because the first connector 10513 is capable of moving in the second track slot 1013 according to a specified track, uncontrolled movement of the first connector 10513 in an entire folding and unfolding process can be avoided, and random movement of the first housing mounting bracket 103 and the second housing mounting bracket 104 can further be avoided, to ensure structural stability and movement stability of the entire hinge mechanism 1. In some cases, the second track slot 1013 is appropriately designed, so that an outer tangent line of the hinge mechanism 1 can keep a constant length in the entire folding and unfolding process, and the flexible display covering the surface of the hinge mechanism 1 can also basically keep a length unchanged. In this way, squeezing or pulling on the flexible display can be effectively avoided, to improve structural reliability of the flexible display and further improve structural reliability of the electronic device.

Still refer to FIG. 4. Similarly structured as the first rotating assembly 1051, the second rotating assembly 1052 is set to be located between the first housing mounting bracket 103 and the second housing mounting bracket 104. In addition, the second rotating assembly 1052 may include a second swing arm 10521, a second support arm 10522, and a second connector 10523. The second connector 10523 is located between the second swing arm 10521 and the second support arm 10522, the second connector 10523 is rotatably connected to the second swing arm 10521, and the second connector 10523 is rotatably connected to the second support arm 10522. In this application, the second connector 10523 may be rotatably connected to the second swing arm 10521 and the first support arm 10512 with reference to how the first connector 10513 is rotatably connected to the second swing arm 10521 and the second support arm 10522. For example, refer to FIG. 14. FIG. 14 may also be used to indicate a structure of the second connector 10523 according to this embodiment of this application. The second connector 10523 may include a third rotating shaft 105231 and a fourth rotating shaft 105232, and an axis of the third rotating shaft 105231 is parallel to and does not coincide with an axis of the fourth rotating shaft 105232. The second connector 10523 may be rotatably connected to the second swing arm 10521 via the third rotating shaft 105231, and the second connector 10523 may be rotatably connected to the second support arm 10522 via the fourth rotating shaft 105232, so that the second swing arm 10521 and the second support arm 10522 perform mutual pulling movement via the second connector 10523.

In addition, refer to FIG. 11. The main shaft 101 may be provided with a third track slot 1014, and the second connector 10523 is capable of moving along the third track slot 1014, for limitation on a movement track of the second connector 10523. In practice, refer to FIG. 7. The base 1011 may be provided with a fourth arc-shaped slot 10114, the second connector 10523 is accommodated in the fourth arc-shaped slot 10114, and the second connector 10523 is capable of sliding along a slot surface of the fourth arc-shaped slot 10114. In addition, refer to FIG. 12. The cover 1012 includes a third protrusion 10124. The third protrusion 10124 may be disposed toward the fourth arc-shaped slot 10114 of the base 1011 in FIG. 7. A gap exists between a surface of the third protrusion 10124 and the slot surface of the fourth arc-shaped slot 10114, and the gap is used as the third track slot 1014.

In this application, as shown in FIG. 14, the second connector 10523 may include a third arc-shaped surface 105233 and a fourth arc-shaped surface 105234. When the electronic device is in the unfolded state and the folded state, the third arc-shaped surface 105233 of the second connector 10523 may abut against the surface 101241 of the third protrusion, and the fourth arc-shaped surface 105234 abuts against the slot surface of the fourth arc-shaped slot 10114. In this way, the surface 101241 of the third protrusion and the slot surface of the fourth arc-shaped slot 10114 limit the second connector 10523 to the third track slot 1014, so that when the hinge mechanism 1 is in the unfolded state and the folded state, the second connector 10523 is relatively stable without any gap-caused shake, and structural reliability of the hinge mechanism 1 is improved in the foregoing two states.

In this embodiment of this application, the third arc-shaped surface 105233 of the second connector 10523 may be disposed with reference to the first arc-shaped surface 105133 of the first connector 10513, and the fourth arc-shaped surface 105234 may be disposed with reference to the second arc-shaped surface 105134 of the first connector 10513. Details are not described herein again. In addition, the third track slot 1014 may be set with reference to the second track slot 1013. Simply speaking, spacings between the surface 101241 of the third protrusion and the slot surface of the fourth arc-shaped slot 10114 are equal, so that the third track slot 1014 is an equal-width slot. In this case, in the processes in which the electronic device changes from the unfolded state to the folded state and from the folded state to the unfolded state, the surface 101241 of the third protrusion keeps an abut-against state with the third arc-shaped surface 105233, and the slot surface of the fourth arc-shaped slot 10114 keeps an abut-against state with the fourth arc-shaped surface 105234. Therefore, in the processes in which the electronic device changes from the unfolded state to the folded state and from the folded state to the unfolded state, movement trajectories of the second connector 10523 in the third track slot 1014 are the same. Alternatively, in the process in which the electronic device changes from the unfolded state to the folded state, the third arc-shaped surface 105233 abuts against the surface 101241 of the third protrusion, and a gap exists between the fourth arc-shaped surface 105234 and the slot surface of the fourth arc-shaped slot 10114. In the process in which the electronic device changes from the folded state to the unfolded state, the fourth arc-shaped surface 105234 abuts against the slot surface of the fourth arc-shaped slot 10114, and a gap exists between the third arc-shaped surface 105233 and the surface 101241 of the third protrusion. In this way, a movement track of the second connector 10523 in the process in which the electronic device changes from the unfolded state to the folded state is different from a movement track of the second connector 10523 in the process in which the electronic device changes from the folded state to the unfolded state.

In this application, the second swing arm 10521 is rotatably connected to the main shaft 101. The second swing arm 10521 and the main shaft 101 may be rotatably connected in a virtual shaft manner. During specific implementation, as shown in FIG. 7, the base 1011 may be provided with a fifth arc-shaped slot 10115. In addition, refer to FIG. 4 and FIG. 19. FIG. 19 may also show a structure of the second swing arm 10521. A third arc-shaped rotating block 105211 is disposed at an end that is of the second swing arm 10521 and that faces the base 1011. The third arc-shaped rotating block 105211 may be but is not limited to a circular-arc-shaped rotating block, and the fifth arc-shaped slot 10115 may be but is not limited to a circular-arc-shaped slot. The third arc-shaped rotating block 105211 may be accommodated in the fifth arc-shaped slot 10115, and is capable of sliding along the slot surface 101151 of the fifth arc-shaped slot. In this way, the rotation of the second swing arm 10521 around the base 1011 is implemented through sliding of the third arc-shaped rotating block 105211 along the slot surface 101151 of the fifth arc-shaped slot. This can help reduce space occupied by the second swing arm 10521 on the main shaft 101, to help reduce a volume of the rotating module 105, and implement a compact design for the hinge mechanism 1. It may be understood that, for the outward folding electronic device, when the second swing arm 10521 is rotatably connected to the main shaft 101 in a virtual shaft manner, an axis center at which the second swing arm 10521 rotates around the main shaft 101 is located on one side that is of the hinge mechanism 1 and that is away from the flexible display.

In addition, in this application, the third arc-shaped rotating block 105211 may be but is not limited to a circular-arc-shaped rotating block, and the fifth arc-shaped slot 10115 may be but is not limited to a circular-arc-shaped slot. It may be understood that, when the third arc-shaped rotating block 105211 is a circular-arc-shaped rotating block, a surface that is of the third arc-shaped rotating block 105211 and that is in contact with the slot surface 101151 of the fifth arc-shaped slot may be a circular arc surface, the slot surface 101151 of the fifth arc-shaped slot is also a circular arc surface, and centers of the two circular arc surfaces coincide with each other.

In this application, to improve stability of rotation of the second swing arm 10521 around the main shaft 101, as shown in FIG. 12, the cover 1012 further includes a fourth protrusion 10125 disposed toward the fifth arc-shaped slot 10115, at least a part of the third arc-shaped rotating block 105211 is located between the fourth protrusion 10125 and the fifth arc-shaped slot 10115, and a surface that is of the third arc-shaped rotating block 105211 and that faces the fourth protrusion 10125 may be in contact with a surface 101251 of the fourth protrusion. In this way, the third arc-shaped rotating block 105211 may be limited between the cover 1012 and the base 1011, and rotation stability of the third arc-shaped rotating block 105211 relative to the base 1011 can be effectively improved. In addition, when the slot surface 101151 of the fifth arc-shaped slot is a circular arc surface, a part that is of the surface 101251 of the fourth protrusion and that is in contact with the third arc-shaped rotating block 105211 may also be a circular arc surface, and centers of the two circular arc surfaces coincide with each other. In this application, a surface that is of the third arc-shaped rotating block 105211 and that faces the fourth protrusion 10125 may be a plane or a circular arc surface, provided that the third arc-shaped rotating block 105211 can rotate relative to the fourth protrusion 10125 in a process in which the third arc-shaped rotating block 105211 slides along the slot surface 101151 of the fifth arc-shaped slot.

To improve reliability of a connection between the second swing arm 10521 and the base 1011, the third arc-shaped rotating block 105211 may further be provided with a second recess 1052111, and an opening of the second recess 1052111 is disposed toward the cover 1012. In addition, a second insertion part (not shown in FIG. 4) may be disposed at an end part that is of the cover 1012 and that faces the second housing mounting bracket 104. In this case, in the folded state, the second insertion part may be inserted into the second recess 1052111, and a surface that is of the second insertion part and that faces the fifth arc-shaped slot 10115 abuts against at least a part of a surface of the second recess 1052111. In this way, a rotation part of the third arc-shaped rotating block 105211 may be limited, and the third arc-shaped rotating block 105211 may be prevented from falling off from the fifth arc-shaped slot 10115.

It should be noted that, in this application, in addition to being rotatably connected to the main shaft 101 in a virtual shaft manner, the second swing arm 10521 may be rotatably connected to the main shaft 101 in a solid shaft manner, so that the first swing arm 10511 can be connected to the main shaft 101 relatively reliably. For the outward folding electronic device, when the first swing arm 10511 is rotatably connected to the main shaft 101 in a solid shaft manner, an axis center at which the first swing arm 10511 rotates around the main shaft 101 is also located on one side that is of the hinge mechanism and that is away from the flexible display.

Specifically, when the second connector 10523 is rotatably connected to the second swing arm 10521 via the third rotating shaft 105231, still refer to FIG. 19. The third arc-shaped rotating block 105211 is provided with a second mounting slot 1052112, and a slot opening of the second mounting slot 1052112 is disposed toward the fourth arc-shaped slot 10114. In this case, the third rotating shaft 105231 may be mounted in the second mounting slot 1052112, a part of the surface of the third rotating shaft 105231 may be in contact with a slot surface of the second mounting slot 1052112, and a part of the surface of the third rotating shaft 105231 is in contact with the slot surface of the fourth arc-shaped slot 10114, to limit the third rotating shaft 105231 to the second mounting slot 1052112.

As shown in FIG. 19, in this application, the slot surface of the second mounting slot 1052112 may include a fifth circular arc surface 10521121. As shown in FIG. 14, the surface that is of the third rotating shaft 105231 and that is in contact with the slot surface of the second mounting slot 1052112 is a sixth circular arc surface 1052311, and a center of the fifth circular arc surface 10521121 coincides with a center of the sixth circular arc surface 1052311. In addition, the slot surface of the fourth arc-shaped slot 10114 is a seventh circular arc surface 101141, the surface that is of the third rotating shaft 105231 and that is in contact with the slot surface of the fourth arc-shaped slot 10114 may be an eighth circular arc surface 1052312, and a center of the seventh circular arc surface 101141 coincides with a center of the eighth circular arc surface 1052312. In this way, when the third rotating shaft 105231 slides along the slot surface of the fourth arc-shaped slot 10114 with the second arc-shaped rotating block 105111, the third rotating shaft 105231 may further rotate relative to the third arc-shaped rotating block 105211, to help implement movement of the second connector 10523 relative to the main shaft 101.

In embodiments of this application, specifically, when the second connector 10523 is rotatably connected to the second support arm 10522 via the fourth rotating shaft 105232, the fourth rotating shaft 105232 may penetrate the second connector 10523 and the second support arm 10522 at the same time. In this case, a connection manner of the second connector 10523 and the second support arm 10522 is relatively simple, which helps simplify a structure of the second rotating assembly 1052, so that a structure of the hinge mechanism 1 can be simplified.

It may be understood that, in the hinge mechanism 1 provided in embodiments of this application, the second connector 10523 may include a plurality of second sub-connectors that are sequentially rotatably connected. In addition, the plurality of second sub-connectors may be located between the second swing arm 10521 and the second support arm 10522. In this case, the second swing arm 10521 may be rotatably connected to an adjacent second sub-connector, and the second support arm 10522 may be rotatably connected to an adjacent second sub-connector. For a manner in which the second swing arm 10521 is rotatably connected to the adjacent second sub-connector and a manner in which the second support arm 10522 is rotatably connected to the adjacent second sub-connector, refer to the foregoing descriptions of the rotatable connection of the second swing arm 10521 and the second support arm 10522 to the second connector 10523. Details are not described herein again. In this application, the second connector 10523 is set as the plurality of second sub-connectors that are sequentially rotatably connected, so that the second swing arm 10521 and the second support arm 10522 are rotatably connected via the plurality of second connectors 10523. This can effectively improve speed uniformity in a process in which the second swing arm 10521 and the second support arm 10522 rotate around the main shaft 101, thereby improving smoothness of mutual pulling movement of the second swing arm 10521 and the second support arm 10522.

In this application, the second swing arm 10521 may be slidably connected to the second housing mounting bracket 104. During specific implementation, the second housing mounting bracket 104 is provided with a third sliding groove 1043. The third sliding groove 1043 and the second mounting part 1042 are disposed at a spacing along the length direction of the hinge mechanism 1. The third sliding groove 1043 extends along a second direction, and the second swing arm 10521 may be mounted in the third sliding groove 1043 and is capable of sliding along the second direction in the third sliding groove 1043. The second direction may be a direction along which the second housing mounting bracket 104 moves toward or away from the base 1011. In addition, to prevent the second swing arm 10521 from falling off from the third sliding groove 1043, a third sliding rail may be disposed on a sliding groove wall of the third sliding groove 1043, and a third sliding block may be disposed on the second swing arm 10521. In this way, the third sliding block may be clamped on the third sliding rail, and the third sliding block is capable of sliding along the third sliding rail, to limit the second swing arm 10521 to the third sliding groove 1043. In addition, the third sliding rail is disposed on the sliding groove wall of the third sliding groove 1043, which may provide guidance for sliding of the second swing arm 10521 along the third sliding groove 1043, to improve movement stability of the second swing arm 10521.

In addition, the second support arm 10522 may be rotatably connected to the first housing mounting bracket 103. During specific implementation, the first housing mounting bracket 103 is provided with a first mounting part 1032. Along the length direction of the hinge mechanism 1, the first mounting part 1032 and the second sliding groove 1033 are disposed at a spacing. An end part that is of the second support arm 10522 and that faces the first housing mounting bracket 103 is mounted on the first mounting part 1032, and an end part that is of the second support arm 10522 and that faces the first housing mounting bracket 103 is rotatably connected to the first mounting part 1032.

In embodiments of this application, a specific manner in which the end part that is of the second support arm 10522 and that faces the first housing mounting bracket 103 is rotatably connected to the first mounting part 1032 is not limited. For example, still refer to FIG. 4. The first mounting part 1032 may be provided with a third mounting hole, and a fourth mounting hole is disposed at an end part that is of the second support arm 10522 and that faces the first housing mounting bracket 103. In this case, the end part that is of the second support arm 10522 and that faces the first housing mounting bracket 103 may be rotatably connected to the first mounting part 1032 via a rotating shaft that penetrates both the third mounting hole and the fourth mounting hole.

Based on the hinge mechanism 1 provided in the foregoing embodiments of this application, in the process in which the electronic device changes from the unfolded state to the folded state, the first housing mounting bracket 103 and the second housing mounting bracket 104 move toward each other. When the second housing mounting bracket 104 drives the second swing arm 10521 to rotate around the main shaft 101 counter-clockwise, the second swing arm 10521 may drive the second connector 10523 to move toward the second swing arm 10521 in the third track slot 1014 of the main shaft 101. In addition, because the second connector 10523 is rotatably connected to the second support arm 10522, in the process in which the second connector 10523 moves toward the second swing arm 10521 in the third track slot 1014 of the main shaft 101, the second support arm 10522 may be driven to rotate around the main shaft 101 clockwise, so that the second support arm 10522 drives the first housing mounting bracket 103 to rotate around the main shaft 101 clockwise. In the process in which the electronic device changes from the folded state to the unfolded state, the first housing mounting bracket 103 and the second housing mounting bracket 104 move away from each other. When the second housing mounting bracket 104 drives the second swing arm 10521 to rotate around the main shaft 101 clockwise, the second swing arm 10521 may drive the second connector 10523 to move toward the second support arm 10522 in the third track slot 1014 of the main shaft 101, and the second support arm 10522 may be driven to rotate around the main shaft 101 counter-clockwise, so that the second support arm 10522 drives the first housing mounting bracket 103 to rotate around the main shaft 101 counter-clockwise. In this way, folding and unfolding functions of the hinge mechanism 1 are implemented.

Some existing hinge mechanisms need to thicken a rotating assembly connected to a main shaft to ensure stability of the mechanisms. In this way, both the main shaft and the hinge mechanism are very heavy. If the main shaft and the hinge mechanism are forcibly thinned, strength of the rotating assembly is easily weakened, thereby greatly affecting reliability of the hinge mechanisms and shortening a life of the electronic device. The hinge mechanism 1 in this application has a simplified structure. According to the foregoing structural relationship, the second connector 10523 may be manufactured with a relatively small cross section to travel back and forth in the third track slot 1014 of the main shaft 101. In addition, the second connector 10523 has a sufficient length extension along a vertical axial direction, and separately has a connection relationship with the second swing arm 10521 and the second support arm 10522, so that reliability of the hinge mechanism 1 can be ensured. In this way, the thickness of the main shaft 101 and the thickness of the entire electronic device can be reduced, and reliability of the hinge mechanism 1 can be maintained, so that the entire hinge mechanism 1 is light, thin, and reliable.

Because the second connector 10523 is capable of moving according to a specified track, uncontrolled movement of the second connector 10523 in an entire folding and unfolding process can be avoided, and random movement of the first housing mounting bracket 103 and the second housing mounting bracket 104 can further be avoided, to ensure structural stability and movement stability of the entire hinge mechanism 1. In some cases, the third track slot 1014 is appropriately designed, so that an outer tangent line of the hinge mechanism 1 can keep a constant length in the entire folding and unfolding process, and the flexible display covering the surface of the hinge mechanism 1 can also basically keep a length unchanged. In this way, squeezing or pulling on the flexible display can be effectively avoided, to improve structural reliability of the flexible display and further improve structural reliability of the electronic device.

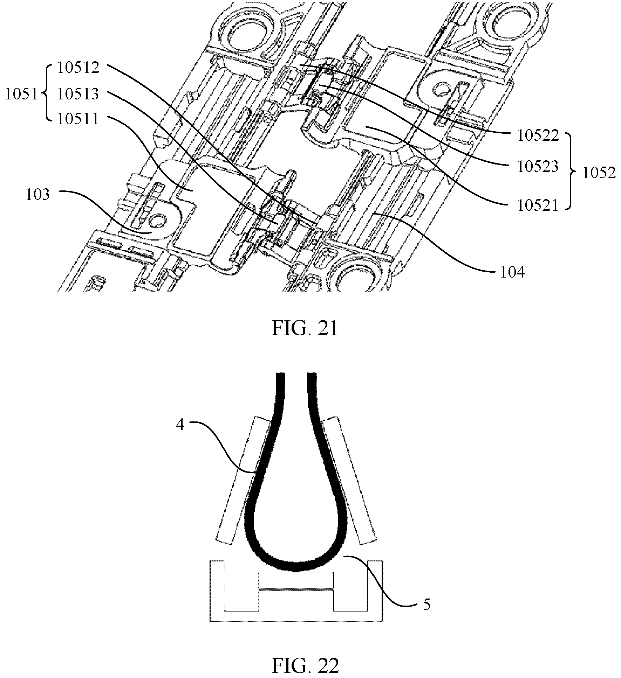

FIG. 21 is a diagram of a partial structure of the hinge mechanism 1 according to an embodiment of this application. The main shaft 101 is omitted in FIG. 21, to help describe a mutual pulling movement relationship between the first rotating assembly 1051 and the second rotating assembly 1052. In this application, the first swing arm 10511 is slidably connected to the first housing mounting bracket 103, the first support arm 10512 is rotatably connected to the second housing mounting bracket 104, and the first swing arm 10511 may pull, via the first connector 10513, the first support arm 10512 to move according to a specified track; and the second swing arm 10521 is slidably connected to the second housing mounting bracket 104, the second support arm 10522 is rotatably connected to the first housing mounting bracket 103, and the second swing arm 10521 may pull, via the second connector 10523, the second support arm 10522 to move according to a specified track. This can limit movement distances of the first housing mounting bracket 103 and the second housing mounting bracket 104 toward or away from the main shaft 101, so that when the electronic device is in any folding state, a distance between the first housing mounting bracket 103 and the main shaft 101 is equal to a distance between the second housing mounting bracket 104 and the main shaft 101. In addition, in the processes in which the electronic device changes from the unfolded state to the folded state and from the folded state to the unfolded state, the first housing mounting bracket 103 is capable of moving at an equal distance relative to the main shaft 101, and the second housing mounting bracket 104 is capable of moving at an equal distance relative to the main shaft 101. In this way, when the hinge mechanism 1 may be used in the electronic device shown in FIG. 2b, an extension length of a support surface formed by the first housing 2, the second housing 3, and the hinge mechanism 1 in the unfolded state can adapt to a flattening length of the flexible display, and when the electronic device is in the folded state, a folding requirement of the foldable part of the flexible display can be met, so that deformation of the flexible display can be avoided, and squeezing or pulling stress on the flexible display can be reduced, to prolong a service life of the flexible display and improve reliability of the electronic device.

According to the hinge mechanism 1 provided in embodiments of this application, a rotation function of the hinge mechanism 1 may be implemented through mutual pulling of the connecting rods. In addition, the two housing mounting brackets may synchronously rotate toward or away from each other by disposing the synchronization assembly 102. In addition, because structures of mechanisms for implementing the rotation function and a synchronization function of the hinge mechanism 1 are simple, the structure of the entire hinge mechanism 1 can be effectively simplified, to help implement a compact design for the hinge mechanism 1 and reduce costs of the hinge mechanism 1. Moreover, because the mechanisms for implementing the rotation function and the synchronization function of the hinge mechanism 1 are two independent mechanisms, a failure of either mechanism does not affect the implementation of the functions of the other mechanism, and the reliability of the hinge mechanism 1 can be effectively improved.

It should be noted that the synchronization assembly 102 described in the foregoing embodiment of this application may be further used in the hinge mechanism 1 of the inward folding electronic device. FIG. 22 is a diagram of a structure of an inward folding electronic device in a folded state according to an embodiment of this application. In a process in which the electronic device changes from an unfolded state to the folded state, the first housing 2 and the second housing 3 synchronously rotate toward each other, so that parts that are of the flexible display 4 and that are fastened to the two housings can be driven to synchronously rotate. In this way, stress on the flexible display 4 can be relatively uniform, to effectively avoid deformation of the flexible display 4 and reduce a risk of damage to the flexible display 4. When the electronic device is in the folded state, the hinge mechanism 1 may form display accommodation space 5 configured to accommodate the foldable part of the flexible display 4, to avoid squeezing on the foldable part of the flexible display 4, and improve structural reliability of the flexible display 4.

In addition, in a process in which the electronic device changes from the folded state to the unfolded state, the first housing 2 and the second housing 3 synchronously rotate away from each other, so that parts that are of the flexible display 4 and that are fastened to the two housings can be driven to synchronously rotate. In addition, when the electronic device is in the unfolded state, the bearing surface 1a of the hinge mechanism 1, the first support surface 2a of the first housing 2, and the second support surface 3a of the second housing 3 jointly flatly support the flexible display 4. This can ensure a complete form of the electronic device in the unfolded state.

It may be understood that, for the inward folding electronic device, when the first swing arm 10511 and the second swing arm 10521 are rotatably connected to the main shaft 101 via virtual shafts, axis centers at which the first swing arm 10511 and the second swing arm 10521 rotate around the main shaft 101 are located on one side that is of the main shaft 101 and that faces the flexible display 4, so that when the electronic device is in the folded state, the flexible display 4 is located inside the electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism, used in a foldable electronic device, wherein the hinge mechanism is disposed opposite to a foldable part of a flexible display of the electronic device, and the electronic device is unfolded or folded via the hinge mechanism; and the hinge mechanism comprises a main shaft, a synchronization assembly, a first housing mounting bracket, and a second housing mounting bracket, the first housing mounting bracket and the second housing mounting bracket are respectively disposed on two opposite sides of the main shaft, and the synchronization assembly is located between the first housing mounting bracket and the second housing mounting bracket, wherein
the synchronization assembly comprises a first connecting rod, a second connecting rod, and a third connecting rod, the second connecting rod is located between the first connecting rod and the third connecting rod, the second connecting rod is rotatably connected to the first connecting rod, the second connecting rod is rotatably connected to the third connecting rod, and an axis along which the second connecting rod is rotatably connected to the first connecting rod is parallel to and does not coincide with an axis along which the second connecting rod is rotatably connected to the third connecting rod; the first connecting rod is rotatably connected to the main shaft, and an axis along which the first connecting rod rotates around the main shaft is parallel to and does not coincide with the axis along which the second connecting rod is rotatably connected to the first connecting rod; and the third connecting rod is rotatably connected to the main shaft, and the third connecting rod is slidably connected to the second housing mounting bracket; and
the first housing mounting bracket is provided with a first track slot, and the first connecting rod is capable of sliding along the first track slot, so that the first housing mounting bracket and the second housing mounting bracket synchronously rotate toward each other or away from each other relative to the main shaft.

2. The hinge mechanism according to claim 1, wherein the main shaft comprises a base, the base is provided with a first arc-shaped slot, the third connecting rod comprises a first arc-shaped rotating block, the third arc-shaped rotating block is accommodated in the first arc-shaped slot, and the first arc-shaped rotating block is capable of sliding along a slot surface of the first arc-shaped slot.

3. The hinge mechanism according to claim 2, wherein the second connecting rod is rotatably connected to the first arc-shaped rotating block.

4. The hinge mechanism according to any one of claims 1 to 3, wherein the hinge mechanism further comprises a rotating module, the rotating module comprises a first rotating assembly and a second rotating assembly, the first rotating assembly is located between the first housing mounting bracket and the second housing mounting bracket, and the second rotating assembly is located between the first housing mounting bracket and the second housing mounting bracket;
the first rotating assembly comprises a first swing arm, a first support arm, and a first connector, the first swing arm is rotatably connected to the main shaft, the first swing arm is slidably connected to the first housing mounting bracket, the first support arm is rotatably connected to the second housing mounting bracket, the first connector is located between the first swing arm and the first support arm, the first connector is rotatably connected to the first swing arm, and the first connector is rotatably connected to the first support arm; and the main shaft is provided with a second track slot, and the first connector is capable of moving along the second track slot, for limitation on a movement track of the first connector; and
the second rotating assembly comprises a second swing arm, a second support arm, and a second connector, the second swing arm is rotatably connected to the main shaft, the second swing arm is slidably connected to the second housing mounting bracket, the second support arm is rotatably connected to the first housing mounting bracket, the second connector is located between the second swing arm and the second support arm, the second connector is rotatably connected to the second swing arm, and the second connector is rotatably connected to the second support arm; and the main shaft is provided with a third track slot, and the second connector is capable of moving along the third track slot, for limitation on a movement track of the second connector.

5. The hinge mechanism according to claim 4, wherein the main shaft comprises a base and a cover, the base is provided with a second arc-shaped slot and a fourth arc-shaped slot, the cover covers the base, and the cover comprises a first protrusion disposed toward the second arc-shaped slot and a third protrusion disposed toward the fourth arc-shaped slot;
a gap between a surface of the first protrusion and a slot surface of the second arc-shaped slot is used as the second track slot, the first connector comprises a first arc-shaped surface and a second arc-shaped surface, and when the electronic device is in an unfolded state and a folded state, the first arc-shaped surface abuts against the surface of the first protrusion, and the second arc-shaped surface abuts against the slot surface of the second arc-shaped slot; and
a gap between a surface of the third protrusion and a slot surface of the fourth arc-shaped slot is used as the third track slot, the second connector comprises a third arc-shaped surface and a fourth arc-shaped surface, and when the electronic device is in the unfolded state and the folded state, the third arc-shaped surface abuts against the surface of the third protrusion, and the fourth arc-shaped surface abuts against the slot surface of the fourth arc-shaped slot.

6. The hinge mechanism according to claim 5, wherein in a process in which the electronic device changes from the unfolded state to the folded state, the first arc-shaped surface abuts against the surface of the first protrusion, and a gap exists between the second arc-shaped surface and the slot surface of the second arc-shaped slot; and in a process in which the electronic device changes from the folded state to the unfolded state, the second arc-shaped surface abuts against the slot surface of the second arc-shaped slot, and a gap exists between the first arc-shaped surface and the surface of the first protrusion; and
in the process in which the electronic device changes from the unfolded state to the folded state, the third arc-shaped surface abuts against the surface of the third protrusion, and a gap exists between the fourth arc-shaped surface and the slot surface of the fourth arc-shaped slot; and in the process in which the electronic device changes from the folded state to the unfolded state, the fourth arc-shaped surface abuts against the slot surface of the fourth arc-shaped slot, and a gap exists between the third arc-shaped surface and the surface of the third protrusion.

7. The hinge mechanism according to claim 5, wherein the surface of the first protrusion is equidistant from the slot surface of the second arc-shaped slot, and in processes in which the electronic device changes from the unfolded state to the folded state and from the folded state to the unfolded state, the first arc-shaped surface abuts against the surface of the first protrusion, and the second arc-shaped surface abuts against the slot surface of the second arc-shaped slot; and the surface of the third protrusion is equidistant from the slot surface of the fourth arc-shaped slot, and in the processes in which the electronic device changes from the unfolded state to the folded state and from the folded state to the unfolded state, the third arc-shaped surface abuts against the surface of the third protrusion, and the fourth arc-shaped surface abuts against the slot surface of the fourth arc-shaped slot.

8. The hinge mechanism according to claim 5, wherein the first arc-shaped surface is a circular arc surface, the second arc-shaped surface is a circular arc surface, and a sum of a radius of the first arc-shaped surface and a radius of the second arc-shaped surface is equal to a spacing between the surface of the first protrusion and the slot surface of the second arc-shaped slot; and
the third arc-shaped surface is a circular arc surface, the fourth arc-shaped surface is a circular arc surface, and a sum of a radius of the third arc-shaped surface and a radius of the fourth arc-shaped surface is equal to a spacing between the surface of the third protrusion and the slot surface of the fourth arc-shaped slot.

9. The hinge mechanism according to any one of claims 4 to 8, wherein the main shaft comprises the base, the base is provided with a third arc-shaped slot and a fifth arc-shaped slot, the first swing arm comprises a second arc-shaped rotating block, the second arc-shaped rotating block is accommodated in the third arc-shaped slot, and the second arc-shaped rotating block is capable of sliding along a slot surface of the third arc-shaped slot, for rotatable connection between the first swing arm and the main shaft; and
the second swing arm comprises a third arc-shaped rotating block, the third arc-shaped rotating block is accommodated in the fifth arc-shaped slot, and the second arc-shaped rotating block is capable of sliding along a slot surface of the fifth arc-shaped slot, for rotatable connection between the second swing arm and the main shaft.

10. The hinge mechanism according to claim 9, wherein the main shaft further comprises the cover, the cover covers the base, the cover comprises a second protrusion disposed toward the third arc-shaped slot, and at least a part of the second arc-shaped rotating block is located between the second protrusion and the third arc-shaped slot; and
the cover further comprises a fourth protrusion disposed toward the fifth arc-shaped slot, and at least a part of the third arc-shaped rotating block is located between the fourth protrusion and the fifth arc-shaped slot.

11. The hinge mechanism according to claim 9 or 10, wherein the first connector comprises a first rotating shaft and a second rotating shaft, the first connector is rotatably connected to the first swing arm via the first rotating shaft, the first connector is rotatably connected to the first support arm via the second rotating shaft, and an axis of the first rotating shaft is parallel to and does not coincide with an axis of the second rotating shaft; and
the second connector comprises a third rotating shaft and a fourth rotating shaft, the second connector is rotatably connected to the second swing arm via the third rotating shaft, the second connector is rotatably connected to the second support arm via the fourth rotating shaft, and an axis of the third rotating shaft is parallel to and does not coincide with an axis of the fourth rotating shaft.

12. The hinge mechanism according to claim 11, wherein the second arc-shaped rotating block is provided with a first mounting slot, a slot opening of the first mounting slot is disposed toward the third arc-shaped slot, the first rotating shaft is mounted in the first mounting slot, a part of a surface of the first rotating shaft is in contact with a slot surface of the first mounting slot, and a part of the surface of the first rotating shaft is in contact with the slot surface of the third arc-shaped slot; and
the third arc-shaped rotating block is provided with a second mounting slot, a slot opening of the second mounting slot is disposed toward the fifth arc-shaped slot, the third rotating shaft is mounted in the second mounting slot, a part of a surface of the third rotating shaft is in contact with a slot surface of the second mounting slot, and a part of the surface of the third rotating shaft is in contact with the slot surface of the fifth arc-shaped slot.

13. The hinge mechanism according to claim 12, wherein the slot surface of the first mounting slot comprises a first circular arc surface, the surface that is of the first rotating shaft and that is in contact with the slot surface of the first mounting slot is a second circular arc surface, and a center of the first circular arc surface coincides with a center of the second circular arc surface; and
the slot surface of the second mounting slot comprises a fifth circular arc surface, the surface that is of the third rotating shaft and that is in contact with the slot surface of the second mounting slot is a sixth circular arc surface, and a center of the fifth circular arc surface coincides with a center of the sixth circular arc surface.

14. The hinge mechanism according to claim 13, wherein the slot surface of the third arc-shaped slot is a third circular arc surface, the surface that is of the first rotating shaft and that is in contact with the slot surface of the third arc-shaped slot is a fourth circular arc surface, and a center of the third circular arc surface coincides with a center of the fourth circular arc surface; and
the slot surface of the fifth arc-shaped slot is a seventh circular arc surface, the surface that is of the third rotating shaft and that is in contact with the slot surface of the fifth arc-shaped slot is an eighth circular arc surface, and a center of the seventh circular arc surface coincides with a center of the eighth circular arc surface.

15. The hinge mechanism according to any one of claims 4 to 14, wherein an axis center at which the first swing arm rotates around the main shaft is located on one side that is of the main shaft and that is away from the flexible display, and an axis center at which the second swing arm rotates around the main shaft is located on one side that is of the main shaft and that is away from the flexible display.

16. The hinge mechanism according to any one of claims 4 to 15, wherein the first rotating assembly comprises a plurality of first sub-connectors that are sequentially rotatably connected, the plurality of first sub-connectors are located between the first swing arm and the first support arm, the first swing arm is rotatably connected to a first sub-connector adjacent to the first swing arm, and the first support arm is rotatably connected to a first sub-connector adjacent to the first support arm; and
the second rotating assembly comprises a plurality of second sub-connectors that are sequentially rotatably connected, the plurality of second sub-connectors are located between the second swing arm and the second support arm, the second swing arm is rotatably connected to an adjacent second sub-connector, and the second support arm is rotatably connected to an adjacent second sub-connector.

17. An electronic device, comprising a first housing, a second housing, a flexible display, and the hinge mechanism according to any one of claims 1 to 16, wherein
the first housing and the second housing are respectively disposed on two opposite sides of the hinge mechanism, a first housing mounting bracket is fastened to the first housing, and a second housing mounting bracket is fastened to the second housing; and
the flexible display continuously covers the first housing, the second housing, and the hinge mechanism, and the flexible display is fastened to the first housing and the second housing.
